(19) Europäisches Patentamt
European Patent Office
Office européen des brevets

(11) **EP 2 673 671 B1**

(12) **EUROPÄISCHE PATENTSCHRIFT**

(45) Veröffentlichungstag und Bekanntmachung des Hinweises auf die Patenterteilung:
**28.08.2019   Patentblatt 2019/35**

(51) Int Cl.:
***G02B 21/24*** *(2006.01)*   ***G02B 21/00*** *(2006.01)*

(21) Anmeldenummer: **12703782.8**

(22) Anmeldetag: **08.02.2012**

(86) Internationale Anmeldenummer:
**PCT/EP2012/052097**

(87) Internationale Veröffentlichungsnummer:
**WO 2012/107468 (16.08.2012 Gazette 2012/33)**

(54) **MIKROSKOP MIT AUTOFOKUSEINRICHTUNG UND VERFAHREN ZUR AUTOFOKUSSIERUNG BEI MIKROSKOPEN**

MICROSCOPE HAVING AN AUTOFOCUSING DEVICE AND AUTOFOCUSING METHOD FOR MICROSCOPES

MICROSCOPE ÉQUIPÉ D'UN DISPOSITIF DE FOCALISATION AUTOMATIQUE ET PROCÉDÉ DE FOCALISATION AUTOMATIQUE POUR MICROSCOPES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **08.02.2011   DE 102011003807**

(43) Veröffentlichungstag der Anmeldung:
**18.12.2013   Patentblatt 2013/51**

(73) Patentinhaber: **Leica Microsystems CMS GmbH**
**35578 Wetzlar (DE)**

(72) Erfinder:
• **KRUEGER, Ralf**
  **35510 Butzbach Griedel (DE)**
• **BAUER, Tobias**
  **61462 Königstein/Ts (DE)**

(74) Vertreter: **m patent group**
**Postfach 33 04 29**
**80064 München (DE)**

(56) Entgegenhaltungen:
DE-A1- 2 518 047       JP-A- S59 116 605
JP-A- 2007 147 749     US-A- 5 956 141
US-A- 6 081 333        US-A1- 2004 051 877
US-A1- 2008 142 681

**Beschreibung**

Die vorliegende Erfindung betrifft ein Verfahren zur Autofokussierung bei der mikroskopischen Untersuchung eines im Fokus eines Mikroskopobjektivs eines Mikroskops liegenden Objekts unter Verwendung eines Autofokusstrahlengangs sowie ein Mikroskop mit einer entsprechenden Autofokuseinrichtung.

Bei der mikroskopischen Untersuchung von Objekten wird in der Regel auf den interessierenden Bereich ("region of interest") fokussiert, um von diesem Bereich ein vergrößertes scharfes Bild für die Untersuchung zu erhalten. Häufig ist es notwendig, den Fokus im Laufe einer Untersuchung nachzustellen, etwa wenn es sich um lebende Objekte ("living-cell"-Anwendungen) handelt und/oder wenn sich aufgrund thermischer Einflüsse oder Vibrationen der optische Abstand zwischen Objektiv und dem interessierenden Bereich ändert. Zum Auffinden und Halten des Fokus werden sogenannte Autofokuseinrichtungen eingesetzt, von denen verschiedene Arten für die Mikroskopie bekannt sind. Die meisten Autofokusverfahren fallen in zwei Kategorien, nämlich Postionserfassung und Bildinhaltsanalyse. Beispiele hierfür werden anhand des weiter unten erläuterten Standes der Technik näher erörtert.

In der Praxis wird häufig der Autofokus auf eine definierte Grenzfläche, z. B. eine Probenfläche an Luft oder eine Grenzfläche zwischen Probenflüssigkeit und Glas, scharf gestellt. Dies kann entweder von Hand durch den Benutzer unter visueller Kontrolle der Probe erfolgen oder durch einen speziellen Fokus-Suchlauf der Autofokuseinrichtung. Die eigentliche mikroskopische Untersuchung kann anschließend mit einem "Offset" arbeiten, indem der Autofokus vom Benutzer auf eine andere, besser antastbare Grenzfläche eingestellt wird als der visuelle Fokus, der auf dem zu untersuchenden interessierenden Bereich liegt. Ein solcher "Autofokus-Offset" setzt voraus, dass der Abstand zwischen diesen beiden Foki bekannt ist, beispielsweise die Deckglasdicke eines mikroskopischen Präparates oder die Bodendicke einer Petrischale, in der sich die visuell beobachtete Probe befindet.

Insbesondere bei lang dauernden mikroskopischen Untersuchungen (beispielsweise von Zellenproben) ist ein Haltefokus auf einer definierten Grenzfläche (beispielsweise zwischen (Deck-) Glas und wässriger Lösung) vorteilhaft, bei dem der vom Benutzer gewählte Fokus stets nachgeregelt wird, wenn er sich etwa aufgrund von Wärmeeffekten oder Schwingungen verstellen sollte.

Stand der Technik

Zu der oben erwähnten Kategorie der positionserfassenden Autofokuseinrichtungen gehört die sogenannte "triangulierende" Autofokuseinrichtung, wie sie aus der US 5,136,149 B1 bekannt ist. Die DE 195 37 376 A1 bezeichnet das in der genannten US-Patentschrift beschriebene Autofokusprinzip als "triangulierendes" Autofokusprinzip. Solche Autofokuseinrichtungen, auch Autofokussierungsabtasteinheiten genannt, verwenden einen schräg oder schief auf ein Objekt fallenden Autofokus-Messstrahl als Autofokusstrahlengang, wobei durch das Objektiv des Mikroskops dieser Messstrahl auf das Objekt fokussiert wird, wo ein Messmuster, in der Regel in Form eines Spots oder Spalts, entsteht. Dieses Autofokusprinzip setzt eine spiegelnde oder regelmäßig reflektierende Autofokus-Grenzfläche voraus. Nach Reflexion tritt der Messstrahl wiederum durch das Mikroskopobjektiv und kann anschließend in einen positionssensitiven Autofokus-Detektor umgeleitet werden. Dieser Detektor detektiert die seitliche Versetzung des Messstrahls. Ändert sich nämlich der Abstand zwischen Objektiv und Autofokusgrenzfläche ("Haltefokus"), so kommt es zu einer seitlichen Versetzung des Messstrahls am Detektor, wodurch somit ein verändertes Signal gegenüber der Fokuslage erzeugt werden kann. Auf diese Weise kann der Grad der Defokussierung gemessen und durch geeignete Mittel wieder kompensiert werden. Eine Möglichkeit der Kompensation ist ein Motor, der die Objektivlinse entsprechend bewegt, um die eingetretene Abstandsänderung zwischen Objektiv und Autofokusgrenzfläche wieder rückgängig zu machen. Nähere Einzelheiten zu Aufbau und Funktionsweise einer triangulierenden Autofokuseinrichtung können den bereits erwähnten Schriften US 5,136,149 B1 und DE 195 37 376 A1 entnommen werden.

Aus der DE 32 19 503 A1 ist eine ähnliche Autofokussierungseinrichtung für optische Geräte, insbesondere Auflichtmikroskope, bekannt. Bei dieser Vorrichtung ist eine Laserautofokusanordnung vorgesehen, die ein Messstrahlenbündel erzeugt, dessen eine Hälfte mittels eines optischen Bauelements abgeblendet wird. Das im Querschnitt auf die Hälfte begrenzte Messstrahlenbündel wird als Autofokus-Messstrahl in den Beleuchtungsstrahlengang des Auflichtmikroskops eingekoppelt, der seinerseits über die Objektivpupille und das Objektiv auf ein Objekt fällt. Auf diese Weise erzeugt der zur Hälfte abgeblendete Messstrahl - vorzugsweise gepulstes Laserlicht im IR-Bereich - einen die mikroskopische Beobachtung nicht störenden Messspot auf dem Objekt für den Autofokus. Bei einer Defokussierung "wandert" dieser Messspot auf der Oberfläche des Objektes. Nach Reflexion an der Objektoberfläche verläuft der remittierte (halbe) Autofokus-Messstrahl zurück zu dem optischen Bauelement (Umlenkprisma) und von dort zu einem Detektor, der im Wesentlichen aus einer Differenzdiode (zwei Dioden) bestehen kann. Ist das System optimal fokussiert, so liegt das Bild des Messspots in exakt symmetrischer Lage bezüglich der beiden Dioden des Detektors. Im Falle der Defokussierung wandert das Bild des Messspots aus der Zentrallage in Richtung einer der beiden Dioden, je nach Richtung der Defokussierung. In erster Näherung ist der Betrag der Verschiebung des Messspots auf der Differenzdiode proportional zum Betrag der Defokussierung. Die Vorrichtung erlaubt, die ermittelte Defokussierung durch entsprechende Gegensteuerung des Objektivs und/oder des Objekttisches in z-Richtung (Richtung der optischen Achse) rückgängig zu machen.

Ein Autofokussystem mit einem ähnlichen Messprinzip ist auch aus der US 2004/0113043 A1 bekannt. Der Zusammenhang zwischen dem Detektionssignal und der tatsächlichen Fokuslage ist in dieser US-Schrift zeichnerisch dargestellt.

Ein ähnliches Autofokussystem für ein inverses Mikroskop mit Durchlichtbeleuchtung ist aus der US 7,345,814 B2 bekannt. Zur Streulichtminimierung sind im Strahlengang der Autofokusvorrichtung ein Polarisationsstrahlteiler sowie ein $\lambda/4$-Plättchen vorgesehen.

Auch die DE 601 16 268 T2 beschreibt verschiedene Ausführungsformen einer Autofokuseinrichtung für ein Screening-Mikroskop hohen Durchsatzes, bei denen Verschiebung und Form eines von einem Autofokusdetektor aufgenommenen Autofokusmessspots analysiert werden, um hieraus den Grad der Defokussierung zu bestimmen und um daraufhin den Fokus während eines Screening-Verfahrens konstant zu halten.

Die WO 2009/092555 A1 beschreibt ein Autofokusverfahren der zweiten Kategorie, nämlich der Bildinhaltsanalyse, für Mikroskope. Dort wird zur Autofokussierung ein schräg im Beleuchtungsstrahlengang in der Leuchtfeldblendenebene eingebautes Gitter mittels einer Autofokusoptik, Umlenkspiegeln und dem Mikroskopobjektiv als Fokussierbild auf ein Objekt abgebildet. Das Gitter kann beispielsweise als Strichgitter ausgebildet sein. Bei der dort beschriebenen Anordnung schließt die Fokussierbildebene, in der das Gitter-Fokussierbild liegt, mit der Fokusebene der Abbildungsoptik des Mikroskops einen bestimmten Winkel ein. Bei optimaler Fokussierung ist das von einer CCD-Kamera des Mikroskops aufgenommene Fokussierbild entlang der Schnittlinie der beiden genannten Ebenen, die in der Bildmitte liegt, am schärfsten, wobei die Schärfe in beiden Richtungen nach außen hin abnimmt. Gleiches gilt für den Kontrast dieses Bildes. Wenn das Objekt defokussiert wird, wandert besagte Schnittlinie in lateraler Richtung, entsprechend verschiebt sich der Ort der besten Abbildung des Gitter-Fokussierbildes. Eine Defokussierung des Objekts (also eine Abweichung in z-Richtung) führt zu einer lateralen Verschiebung des Ortes der schärfsten Abbildung am CCD-Detektor. In dieser Schrift wird vorgeschlagen, aus dem von der CCD-Kamera aufgenommenen Fokussierbild ein Intensitätsprofil abzuleiten und hieraus Intensitäten zu ermitteln, die in Abhängigkeit des Abstandes z von der Fokusebene aufgetragen werden können. Im Ort des optimalen Fokus liegt dann ein Intensitätsmaximum. Weiterhin kann durch eine Faltungsoperation aus dem Intensitätsprofil ein Kontrastprofil abgeleitet werden. Wiederum liegt im Ort der optimalen Fokussierung ein Kontrastmaximum. Eine Steuereinrichtung berechnet aus den Profilen die Defokussierung und kompensiert diese mittels entsprechender Verschiebung des Objekttisches des Mikroskops.

Bei den oben beschriebenen triangulierenden Autofokuseinrichtungen wird die laterale Verschiebung von Schwerpunkt des Messspots, Kantenlage des Messspots- oder -spalts oder ein angefittetes Profil als Signal benutzt, aus dem der Grad der Defokussierung abgeleitet wird. Bei der zuletzt geschilderten Autofokussiereinrichtung wird ein solches Signal aus der Intensität bzw. dem Kontrast eines abgebildeten Gitters gewonnen. Für das auszuwertende Signal ist die komplette Abbildungsstrecke von der Lichtquelle bzw. von einer Struktur in der Leuchtfeldblendenebene, über das Objektiv und das Objekt bis hin zum Detektor maßgeblich. Verschieben sich aufgrund thermischer Drift Bauelemente wie Leuchtquelle, Detektor oder Umlenkelemente, beeinflusst dies direkt das Signal. Hierdurch werden Fehler bei der Bestimmung der Defokussierung verursacht mit einer hieraus folgenden Ungenauigkeit der Autofokussierung. Typischerweise dauert es zwei Stunden und mehr bis ein entsprechender Aufbau thermisch ausreichend stabil ist, um präzise Langzeitexperimente durchführen zu können.

Bei einem Verfahren gemäß WO 2009/092555 A1 (siehe obige Ausführungen) wird überdies die Grenzfläche Deckglas zu wässrigem Einbettmedium der Probe auf den Detektor abgebildet, wobei direkt die Grenzfläche auf den CCD-Detektor abgebildet wird. In dieser Grenzfläche befinden sich zum einen die Zellen, die beobachtet werden sollen, zum anderen aber auch Unsauberkeiten, Kratzer, Blasen und sonstige Störungen, die direkt dem Bild und somit dem abzuleitenden Signal überlagert sind und in der Folge die Auswertung erschweren oder verfälschen.

Die DE 25 18 047 A1 offenbart ein Interferometer zur Untersuchung der Topografie einer Fläche. Ein einfallender Lichtstrahl wird mittels einer Interferometerplatte in zwei Teilstrahlen aufgespalten. Diese Teilstrahlen werden mittels einer Objektivlinse auf die zu untersuchenden Fläche fokussiert. Die reflektierten Strahlenbündel gelangen über das Objektiv wiederum auf die Interferometerplatte, um nach Reflexion in einem einzigen Lichtstrahl vereinigt zu werden. Der vereinigte Strahl gelangt dann in die Bildebene eines Mikroskops. Je nach Struktur der Oberfläche variiert der Lichtwegunterschied zwischen den reflektierten Lichtbündeln, so dass es mit dieser Anordnung möglich ist, die Topografie der Fläche interferometrisch zu untersuchen.

Die US 2008/0142681 A1 betrifft die Vermessung einer Phasenverschiebungsmaske mittels eines Interferenzbildes. Die Maske liegt hierbei in der Fokusebene eines Objektivs. Der die Maske durchsetzende Lichtstrahl, der von einer Lichtquelle und einer nachgeschalteten Linse erzeugt wird, wird mittels eines Strahlteilers in zwei Teilstrahlen aufgespalten. Mittels Keilplatten werden die resultierenden Bilder lateral versetzt und über einen Strahlteiler einander wieder überlagert und auf eine bildgebende Einrichtung mittels nachgeschalteter Linsen abgebildet. Die bildgebende Einrichtung nimmt somit ein Interferenzbild von der Phasenverschiebungsmaske auf. Unabhängig von der Aufnahme eines Interferenzbildes erfolgt eine Autofokussierung. Bei der Autofokussierung handelt es sich hier um eine bekannte Art der Autofokussierung mittels einer eigenen Autofokuslichtquelle mit einer Teilerdiode zur Detektion einer Defokussierung.

Die US 6,081,133 behandelt ein Interferometer zur Messung der Konvergenz/Divergenz eines Laserstrahls, der große Distanzen zurücklegt. Der Laserstrahl trifft auf zwei Keilplatten, wodurch auf einem Detektor zwei Bildabschnitte entstehen, die jeweils aus einem eigenen typischen Interferenzmuster bestehen. Diese unterscheiden sich abhängig vom Konvergenzgrad des Laserstrahls. Die Muster bei einem kollimierten Laserstrahl zeichnen sich durch einheitliche Symmetrie im oberen und unteren Teil aus.

Die JP S59 116605 A beschäftigt sich mit der Fokuserkennung basierend auf Licht, das von einer Oberfläche reflektiert wird. Hierzu wird Licht von einer Lichtquelle über eine Umlenkeinrichtung auf das Objekt gelenkt, reflektiertes Licht wird an einer weiteren Umlenkeinrichtung bzw. einem Strahlteiler in zwei Teilstrahlen geteilt, die auf einen Detektor gelenkt werden und ein Interferenzmuster erzeugen.

Die JP 2007 147749 A beschäftigt sich allgemein mit der Verwendung einer Interferenz von Teilstrahlen, um eine Autofokussierung bei einem Mikroskop vorzunehmen. Hierbei wird Licht von einer Lichtquelle über eine Umlenkeinrichtung auf das Objekt gelenkt, reflektiertes Licht wird an einer weiteren Umlenkeinrichtung auf einen Detektor gelenkt.

Außerdem wird ein Teilstrahl vor der Umlenkeinrichtung mittels einer anderen Umlenkeinrichtung ausgekoppelt und als eine Art Referenzstrahl, der getrennt von dem zuvor erwähnten Messstrahl verläuft, auf den - geteilten - Detektor gelenkt. Anhand der mittels dieses geteilten Detektors aufgenommener Bilder kann beurteilt werden, ob das Objekt im Fokus liegt.

Vor diesem Hintergrund stellt sich die Aufgabe, ein Verfahren und eine Vorrichtung zur Autofokussierung bei Mikroskopen anzugeben, welche eine schnelle und präzise Autofokussierung bei weniger starker Fehleranfälligkeit erlauben.

Diese Aufgabe wird erfindungsgemäß durch die Merkmale der unabhängigen Patentansprüche gelöst. Vorteilhafte Ausgestaltungen der Erfindung ergeben sich aus den jeweiligen Unteransprüchen und der nachfolgenden Beschreibung.

Beim erfindungsgemäßen Verfahren zur Autofokussierung bei der mikroskopischen Untersuchung eines im Fokus eines Mikroskopobjektivs eines Mikroskops liegenden Objekts unter Verwendung eines Autofokusstrahlengangs wird dieser über eine auf der objektabgewandten Mikroskopobjektivseite angeordnete Umlenkeinrichtung in Richtung Mikroskopobjektiv und von dort auf eine reflektierende Autofokus-Grenzfläche im Objektbereich gelenkt und der an dieser Autofokus-Grenzfläche reflektierte Autofokusstrahlengang über das Mikroskopobjektiv und die Umlenkeinrichtung in Richtung eines Autofokusdetektors gelenkt. Die Umlenkeinrichtung weist zur Erzeugung interferierender Teilstrahlen des Autofokusstrahlengangs zwei in Ausbreitungsrichtung des Autofokusstrahlengangs hintereinander angeordnete, also zueinander beabstandete Bereiche auf, die den Autofokusstrahlengang jeweils zumindest zum Teil reflektieren. Der Autofokusdetektor ist in einer zur Mikroskopobjektivpupille konjugierten Ebene angeordnet, um ein dort (und folglich auch in der Mikroskopobjektivpupille selbst) erzeugtes Interferenzmuster aufzunehmen. Abhängig von diesem aufgenommenen Interferenzmuster wird anschließend der Fokus des Mikroskops eingestellt, wobei hierunter eine anfängliche Fokuseinstellung (sogenannter Fokus-Suchlauf) aber auch ein Halten einer zuvor eingestellten Fokusposition während der mikroskopischen Untersuchung verstanden werden soll.

Grundidee der vorliegenden Erfindung ist die Autofokussierung mittels Interferometrie. Hierzu wird der Autofokusstrahlengang in Teilstrahlen gesplittet bzw. aufgespalten, die zur Interferenz gebracht werden. Diese Interferenz muss sensitiv sein gegenüber einer Fokusverschiebung, also bezüglich der Änderung des Abstandes zwischen Objekt, genauer gesagt zwischen einer reflektierenden Autofokus-Grenzfläche im Objektbereich, und Mikroskopobjektiv. Bei der vorgeschlagenen Erfindung handelt es sich somit um eine neue Kategorie eines Autofokussierungsverfahrens neben den bereits erwähnten Kategorien der Autofokussierung mittels Positionserfassung und Bildanalyse. Es hat sich gezeigt, dass ein von einem Autofokusdetektor, z.B. einem CCD-Chip, aufgenommenes Interferenzmuster sich hinsichtlich verschiedener Eigenschaften, die sich fokusabhängig verändern, ausgewertet werden kann, um hieraus Signale abzuleiten, um eine Fokuseinstelleinrichtung anzusteuern, die ihrerseits eine vorhandene Defokussierung rückgängig macht bzw. einer Defokussierung entgegensteuert.

Es sei bereits jetzt darauf hingewiesen, dass ein weiter unten zu erläuternder Aufbau möglich ist, bei dem im Falle der optimalen Fokuseinstellung kein Interferenzmuster sichtbar ist, und bei dem erst im Falle der Defokussierung ein Interferenzmuster auftritt. Bei einem solchen Aufbau wird folglich der Fokus des Mikroskops abhängig von dem aufgenommenen Interferenzmuster so eingestellt, dass dieses verschwindet.

Bei dem aufgenommenen Interferenzmuster handelt es sich in aller Regel um ein Interferenzstreifenmuster. Bevorzugt ist ein ebenfalls weiter unten näher erläuterter Aufbau, bei dem im Falle der optimalen Fokuseinstellung ein charakteristisches Interferenzstreifenmuster vorliegt, also detektiert wird, wobei sich bei Defokussierung die Eigenschaften des Interferenzstreifenmusters ändern.

Zu den genannten fokusabhängigen Eigenschaften des Interferenzmusters zählen die Orientierung der Streifen im Interferenzmuster, deren Dichte sowie der Phasenwinkel des Interferenzmusters. Durch Interferenz der Teilstrahlen des Autofokusstrahlengangs entsteht - wie weiter unten ausführlich erläutert - auf der sensitiven Detektorfläche ein Interferenzstreifenmuster. Es kann auch ein Aufbau gewählt werden, bei dem ein Interferenzstreifenmuster erst bei vorhandener Defokussierung auftritt. Abhängig vom Grad der Defokussierung ändert sich die Orientierung, mit anderen Worten die Neigung oder der Neigungswinkel, der Streifen im Interferenzmuster, aber auch deren Dichte. Schließlich ändert sich der "Phasenwinkel" des Interferenzmusters. Hierunter wird folgendes verstanden: Mit zunehmender Defokussierung verschieben sich die Streifen derart, dass ein Streifen den Platz des nächsten einnimmt u.s.f. Dieser Effekt ist bei Interferenzmustern in der Physik allgemein bekannt. Es kann ein Phasenwinkel von 360° definiert werden, der durchlaufen ist, wenn ein Streifen den Platz des nächsten eingenommen hat. Entsprechende Teilstrecken können dann mit einem Phasenwinkel zwischen 0° und 360° beschrieben werden. Mit "Streifen" ist ein Helligkeitsmaximum oder Helligkeitsminimum im Interferenzmuster gemeint.

Es hat sich gezeigt, dass sich die Dichte der Streifen im Interferenzmuster, mit anderen Worten deren Ortsfrequenz, vorteilhaft für die Auswertung des Interferenzmusters zum Zwecke der Autofokussierung heranziehen lässt. Es hat sich weiterhin gezeigt, dass besagter Phasenwinkel des Interferenzmusters sehr empfindlich, d. h. mit hoher Dynamik, auf geringste Defokussierungen reagiert. Es ist daher vorteilhaft, die Fokuseinstellung zunächst anhand der Auswertung der Streifendichte im Interferenzmuster vorzunehmen und - falls gewünscht - zur Feineinstellung des Fokus zusätzlich den Phasenwinkel des Interferenzmusters auszuwerten. Weitere Details zur Auswertung und Ausgestaltungen hierzu werden weiter unten ausführlich beschrieben werden.

Es sei darauf hingewiesen, dass bei der vorgeschlagenen Erfindung der Detektor nicht wie bei den bisher bekannten Kategorien der Autofokussierung in der Bildebene angeordnet ist, sondern in einer zur Mikroskopobjektivpupille konjugierten Ebene.

Weiterhin sei darauf hingewiesen, dass das Grundprinzip der Erfindung sich prinzipiell auch mit einem aus dem Stand der Technik bekannten Mirau- oder Michelson-Interferometer realisieren lassen könnte. Solche Anordnungen hätten jedoch gegenüber der erfindungsgemäß vorgeschlagenen Anordnung mehrere Nachteile: Der Aufbau eines Michelson-Interferometers setzt einen Referenzstrahlengang mit entsprechenden optischen Weglängen ("Armen") voraus, die zu platzaufwendig wären. Der Aufbau eines Mirau-Interferometers benötigt einen Referenzspiegel, für dessen Unterbringung zwischen Objektiv und Probe bei den hier betrachteten Mikroskopen kein Platz vorhanden wäre.

Erfindungsgemäß wird eine fokussensitive Interferenz wie folgt hergestellt: Der Autofokusstrahlengang wird mittels der oben genannten Umlenkeinrichtung in den Mikroskopstrahlengang eingekoppelt, um durch das Mikroskopobjektiv hindurch auf die genannte Autofokus-Grenzfläche im Objektbereich zu fallen. Da die Umlenkeinrichtung zwei beabstandete, den Autofokusstrahlengang jeweils reflektierende Bereiche oder Abschnitte aufweist, die in Ausbreitungsrichtung des Autofokusstrahlengangs hintereinander angeordnet sind, wird der Autofokusstrahlengang aufgespalten: Zum einen wird ein Teilstrahl an dem in Ausbreitungsrichtung vorne liegenden Bereich reflektiert, im folgenden als erster vorderer Teilstrahl bezeichnet, zum anderen wird ein anderer Teilstrahl an dem in Ausbreitungsrichtung dahinter angeordneten Bereich reflektiert, im folgenden als erster hinterer Teilstrahl bezeichnet. Beide Teilstrahlen laufen zunächst parallel in Richtung Objektiv. Hierbei sei angenommen, dass das Umlenkelement in einem Winkel von 45° zum einfallenden Autofokusstrahlengang angeordnet ist. Beide Teilstrahlen treffen sich im Fokus des Mikroskopobjektivs und werden an der reflektierenden Autofokus-Grenzfläche im Objektbereich, die ihrerseits im Fokus liegt, reflektiert. Diese Teilstrahlen gelangen wiederum über das Mikroskopobjektiv zurück zum Umlenkelement, an dem wiederum ein jeder der Teilstrahlen an dem vorderen und dem dahinter liegenden Bereich der Umlenkeinrichtung reflektiert wird. Die derart reflektierten Teilstrahlen laufen schließlich zu einem Autofokusdetektor, der in einer Ebene angeordnet ist, die zur Mikroskopobjektivpupille konjugiert ist. Der beispielsweise als CCD-Kamera ausgestaltete Detektor erzeugt ein Bild, das Interferenzen verschiedener Ordnungen der Teilstrahlen zeigt, die den Detektor erreichen. Interferenzen höherer Ordnung sind licht- und kontrastärmer. Die beim Hin- und Rücklauf jeweils an den vorderen Bereichen der Umlenkeinrichtung reflektierten Teilstrahlen führen zu einem gleichmäßig ausgeleuchteten Abschnitt auf der Detektorfläche ("Bereich 1"). Ein Teil des ersten vorderen Teilstrahls wird nach dem Zurücklaufen zur Umlenkeinrichtung an deren hinteren Bereich reflektiert, während ein Teil des ersten hinteren Teilstrahls nach dem Zurücklaufen zur Umlenkeinrichtung an deren vorderem Bereich reflektiert wird. Diese beiden reflektierten Teilstrahlen interferieren bei Vorhandensein optischer Wegdifferenzen, wodurch sich ein gut auswertbares Interferenzstreifenmuster auf der Detektorfläche ergibt ("Bereich 2"). Weitere mögliche Interferenzen ergeben sich durch Überlagerungen weiterer Teilstrahlen. Diese Interferenzen in weiteren Bereichen ("Bereich 3" etc.) auf der Detektorfläche sind jedoch licht- und kontrastärmer und können daher weniger gut zur Auswertung herangezogen werden, wenngleich nicht ausgeschlossen werden soll, dass eine Auswertung dieser Interferenzmuster erfolgen kann.

Der beschriebene Aufbau kann durch Wahl des Abstandes der zwei beabstandeten reflektierenden Bereiche der Umlenkeinrichtung für den eingekoppelten Autofokusstrahlengang (also den auf das Umlenkelement einfallenden) und den ausgekoppelten Autofokusstrahlengang (also den vom Umlenkelement in Richtung Detektor verlaufenden Autofokusstrahlengang) in folgender Weise variiert werden: Ist der Abstand der Bereiche gleich, beispielsweise bei Verwendung eines planparallelen Teilers oder allgemein zweier beabstandeter, den Autofokusstrahlengang jeweils reflektierender planparalleler Flächen, entsteht auf dem Autofokusdetektor bei optimaler Fokuseinstellung kein Interferenzstreifenmuster . Deutliche Interferenzstreifen treten erst bei einer Defokussierung auf, die dazu führt, dass die Teilstrahlen unterschiedliche optische Weglängen durchlaufen.

Wird der Abstand der genannten Bereiche jedoch unterschiedlich gewählt, so ergibt sich bereits in der optimalen Fokuseinstellung eine "Grundinterferenz" bspw. im oben beschriebenen "Bereich 2" auf der Detektorfläche, da die entsprechenden Teilstrahlen unterschiedliche optische Weglängen durchlaufen. Ausgehend von dieser Grundinterferenz lässt sich eine Defokussierung aufgrund einer Veränderung des Interferenzmusters detektieren und rückgängig machen. Eine Möglichkeit, besagte Bereiche der Umlenkeinrichtung in unterschiedlichen Abständen auszuführen, ist die Verwendung einer Keilplatte. Der Keilwinkel kann derart gewählt werden, dass im Fall der optimalen Fokuseinstellung eine "Grundinterferenz" sichtbar wird, die sich je nach Richtung der Defokussierung ändert. So kann bei Defokussierung in einer ersten Richtung der durch den Keilwinkel vorhandene optische Weglängenunterschied verstärkt werden, während bei einer Defokussierung in die andere Richtung die durch den Keilwinkel verursachte optische Weglängendifferenz kompensiert wird. Bei einer solchen Ausgestaltung kann die Fokuseinstellung über einen relativ großen Bereich erfolgen.

In einer anderen Ausgestaltung kann der Keilwinkel der als Umlenkeinrichtung dienenden Keilplatte in einer Weise gewählt werden, dass es zu einer Überlagerung von Interferenzen aus verschiedenen Raumrichtungen kommt. Bei einer weiter unten noch zu erläuternden Orientierung des Keilwinkels können als "Grundinterferenz" bei optimaler Fokuseinstellung auf der Detektorfläche in vorgegebener Richtung ausgerichtete Interferenzstreifen erzeugt werden, die in vorteilhafter Weise als Sollwert der Fokuseinstellung dienen können. Zur Autofokussierung werden Charakteristika dieses Interferenzstreifenmusters, wie Streifendichte und/oder Streifenneigung, ausgewertet. Im Falle einer Defokussierung ändert sich dieses Grundinterferenzmuster, d. h. es verändert seine Charakteristika, wie Streifenneigung und Streifendichte. Außerdem ändert sich auch der bereits erläuterte Phasenwinkel, der zur Auswertung hinzugezogen werden kann.

Es hat sich gezeigt, dass die Verwendung einer Keilplatte als Umlenkelement und somit das Vorhandensein eines Grundinterferenzmusters in der optimalen Fokuseinstellung vorteilhaft ist, um eine Defokussierung schnell und präzise zu erfassen. Hierbei ist bereits ein kleiner Keilwinkel von wenigen Winkelminuten der Keilplatte ausreichend. Die Verwendung einer Keilplatte hat den weiteren Vorteil einer geringeren Streulichtempfindlichkeit. Der alternative Aufbau mit einer planparallelen dichroitischen Platte, bei dem im Falle der optimalen Fokuseinstellung keine Interferenzstreifen zu beobachten sind, sondern erst im Falle der Defokussierung Interferenzstreifen auftreten, ist zwar mit vorliegender Erfindung realisierbar, jedoch weniger bevorzugt.

Das erfindungsgemäß vorgeschlagene Autofokussierverfahren lässt sich prinzipiell mit beliebigen Lichtquellen zur Erzeugung des Autofokusstrahlengangs realisieren. Beispielsweise kann eine übliche Weißlichtquelle verwendet werden. Zur Kontrasterhöhung des detektierten Interferenzmusters ist es zweckmäßig, die Weißlichtquelle mit einem monochromen Filter zu betreiben. In der Praxis wird vorzugweise eine LED-Lichtquelle eingesetzt. Auch monochromatisches Laserlicht ist verwendbar; allerdings muss wegen der sehr großen Kohärenzlänge des Laserlichts mit Störinterferenzen gerechnet werden, weil auch die übrigen optischen Grenzflächen des Mikroskops (außer dem Umlenkelement) zu den Interferenzen beitragen können. Die Wellenlänge des Autofokusstrahlengangs sollte zweckmäßigerweise außerhalb der Wellenlängenbereiche liegen, die für die mikroskopische Untersuchung verwendet werden. Als günstig haben sich Frequenzen im infraroten Spektralbereich erwiesen.

Es ist vorteilhaft, als Umlenkeinrichtung einen den Autofokusstrahlengang wenigstens zum Teil reflektierenden dichroitischen Teiler, kurz Dichroit genannt, einzusetzen, dessen zwei im Autofokusstrahlengang liegende Begrenzungsflächen die zwei in Ausbreitungsrichtung beabstandeten, den Autofokusstrahlengang reflektierenden Bereiche bilden.

Es wird ein Dichroit verwendet, der für die Wellenlänge des Autofokusstrahlengangs überwiegend reflektierend ist, während es für die mikroskopischen Beobachtungswellenlängen überwiegend transmissiv ist. Auf diese Weise wird vermieden, dass Licht vom Autofokusstrahlengang in den Beobachtungsstrahlengang des Mikroskops gelangt. Weiterhin wird erreicht, dass der in den Mikroskopstrahlengang eingekoppelte Autofokusstrahlengang größtenteils den Autofokusdetektor erreicht. Es hat sich gezeigt, dass die physikalischen Begrenzungsflächen eines solchen dichroitischen Teilers, die in der Regel planparallel zueinander verlaufende Ebenen darstellen, bestens zur Erzeugung von Teilstrahlen des Autofokusstrahlengangs geeignet sind.

Die zwei beabstandeten Bereiche der Umlenkeinrichtung können planparallel zueinander verlaufen oder als keilförmig unter einen Keilwinkel zueinander verlaufende Ebenen ausgebildet sein. Grundvoraussetzung ist, dass der Autofokusstrahlengang auf zwei in seiner Ausbreitungsrichtung liegende reflektierende Bereiche trifft, wodurch er in Teilstrahlen aufgespalten wird. Verlaufen besagte Bereiche planparallel zueinander, sind die optischen Weglängen der für den oben definierten "Bereich 2" der Detektorfläche verantwortlichen Teilstrahlen gleich und es kommt im Fall der optimalen Fokuseinstellung zu keinem Interferenzmuster, sondern erst im Fall der Defokussierung. Im Falle der keilförmig unter einem Keilwinkel zueinander verlaufenden ebenen Bereiche haben diese Teilstrahlen bereits in der Fokusstellung unterschiedliche optische Weglängen. So kommt es bereits im Fall der optimalen Fokuseinstellung zu einer "Grundinterferenz", also einem Grundinterferenzmuster, das als Sollgröße verwendet werden kann. Im Falle der Defokussierung kommt es hiervon ausgehend zu Änderungen des Grundinterferenzmusters hinsichtlich Orientierung und Dichte der Streifen und hinsichtlich des Phasenwinkels des Interferenzmusters, wie bereits oben ausgeführt.

Als Keilwinkel kann ein Winkel zwischen 0,5' bis 10' gewählt werden, wobei mit zunehmendem Keilwinkel die Streifendichte erhöht, der Kontrast des Interferenzstreifenmusters jedoch verringert wird. Zur Auswertung des Streifenmusters ist ein dementsprechend empfindlicherer Detektor notwendig. Vorzugsweise wird als Keilwinkel ein Winkel zwischen 0,5' bis 2' gewählt, weil dies auch mit einem durchschnittlich empfindlichen Detektor eine gute Auswertung des kontrastreichen Interferenzstreifenmusters erlaubt.

Wie bereits in der Beschreibungseinleitung erläutert, ist es sinnvoll, die Autofokussierung unter einem "Offset" zu betreiben, also nicht die visuell beobachtete Probe anzutasten, sondern die Fokusposition des Autofokusstrahlengangs auf eine gut reflektierende Grenzfläche im Objektbereich zu legen ("Autofokus-Grenzfläche"). Hierzu besonders geeignet ist die Grenzfläche zwischen Deckglas, hier typischerweise als Boden einer Petrischale ausgebildet, und Probenmedium. Alternativ kann die Grenzfläche zwischen der der Probe abgewandten Seite des Deckglases und der Luft, insbesondere zwischen der dem Probenmedium abgewandten Seite des Petrischalenbodens und der Luftzwischen Petrischale und dem darunter angeordneten Objektiv des inversen Mikroskops für die Antastung mit dem Autofokusstrahlengang verwendet werden.

Im Folgenden soll die Auswertung des Interferenzmusters näher erläutert werden:
Das Interferenzstreifenmuster kann hinsichtlich der Streifendichte, also der Ortsfrequenz der Interferenzstreifen, ausgewertet werden. Wie weiter unten erläutert werden wird, lässt sich mittels Fouriertransformation eine lineare Kennlinie ableiten, die zur Fokuseinstellung verwendet werden kann.

Es kann weiterhin die Orientierung der Streifen im Interferenzmuster ausgewertet werden. Hierzu wird der Neigungswinkel der Streifen im Interferenzmuster abhängig vom Grad der Defokussierung aufgetragen. Auch die hieraus resultierende Kennlinie kann zur Fokuseinstellung verwendet werden. Hierauf wird weiter unten noch eingegangen werden.

Schließlich kann der Phasenwinkel des Interferenzmusters abhängig vom Grad der Defokussierung aufgezeichnet werden. Hieraus resultieren steile Kennlinien, die sich insbesondere zur Feineinstellung verwenden lassen, also zur präzisen Autofokussierung in einem kleinen Bereich um den Fokus herum. Auch hierauf wird später noch ausführlicher eingegangen werden.

In der Praxis ist es zweckmäßig, die Fokuseinstellung zunächst anhand der Auswertung der Streifendichte im Interferenzmuster vorzunehmen und anschließend zur Feineinstellung des Fokus zusätzlich den Phasenwinkel des Interferenzmusters auszuwerten. In der Praxis hat sich diese Methode der Auswertung der Streifendichte gefolgt von der Auswertung des Phasenwinkels als die am besten geeignete erwiesen.

Zur Auswertung des Interferenzmusters, insbesondere hinsichtlich der Streifendichte, ist der Einsatz einer Fouriertransformation, insbesondere einer Fast-Fouriertransformation (FFT), vorteilhaft, wobei hierzu ein Ausschnitt des vom Autofokusdetektor aufgenommenen Interferenzmusters fouriertransformiert wird.

Zur Erläuterung der Auswertung des Interferenzmusters mittels Fouriertransformation sei angenommen, dass im Fall der optimalen Fokuseinstellung vom Autofokusdetektor ein Grundinterferenzmuster aufgenommen wird, das aus in vertikaler Richtung verlaufenden, abwechselnd hellen und dunklen Streifen (entsprechend den Intensitäts-Maxima und Intensitäts-Minima im Interferenzmuster) besteht. Im Falle der Defokussierung, beispielsweise einer Verschiebung der Grenzfläche um 50 $\mu$m unterhalb des Fokus, neigen sich die Streifen nach rechts, d. h. der Neigungswinkel, bezogen auf die Vertikale, wird negativ. Gleichzeitig erhöht sich die Streifendichte. Unter diesen Annahmen wird nun die Auswertung mittels Fouriertransformation näher erläutert, wobei die Grundprinzipien der Fouriertransformation als bekannt unterstellt werden:
Durch eine Fouriertransformation wird ein im Ortsraum bestehendes Muster in den Ortsfrequenzraum transformiert, so dass die im Muster vorhandenen Ortsfrequenzen in x- und y-Richtung sichtbar werden. Bei einem vertikalen Streifenmuster, bei dem die Streifen parallel zur y-Achse im Ortsraum verlaufen, erhält man somit im Ortsfrequenzraum ein Maximum in x-Richtung an der Stelle, die der Frequenz der Streifen entspricht. Des Weiteren erhält man bei der Ortsfrequenz Null ein Hauptmaximum, das der gemittelten Helligkeit des Musters entspricht, sowie ein weiteres Maximum in x-Richtung an einer Stelle, die der Frequenz der Streifen mit negativem Vorzeichen entspricht. Im Folgenden sei das Maximum bei der Ortsfrequenz Null als "Hauptmaximum" bezeichnet, während die beiden Maxima an den Stellen positiver bzw. negativer Ortsfrequenz jeweils als "Nebenmaxima" bezeichnet seien.
Im Falle eines Streifenmusters mit negativem Neigungswinkel erhält man durch Fouriertransformation wiederum ein Hauptmaximum im Ortsfrequenzraum zusammen mit Nebenmaxima, die seitlich des Hauptmaximums angeordnet sind. Da in diesem Fall Ortsfrequenzen sowohl in x-Richtung als auch in y-Richtung vorliegen, haben die entsprechenden Maxima im Ortsfrequenzraum jeweils Komponenten in x-Richtung sowie in y-Richtung. Es zeigt sich, dass sich gegenüber der Fouriertransformation des vertikalen Streifenmusters die relative Lage der Maxima zueinander, also der Abstand der Maxima, sowie die absolute Lage der Maxima geändert hat. Betrachtet man die beiden Nebenmaxima im Ortsfrequenzraum, so stellt man eine Veränderung des Abstandes der Nebenmaxima sowie eine veränderte Orientierung der Verbindungslinie der Nebenmaxima fest. In den weiter unten behandelten Ausführungsbeispielen wird dieser Fall anschaulich behandelt.

Durch Auswertung der relativen Lage der Maxima, insbesondere der beiden um das Hauptmaximum herum liegenden Nebenmaxima, zueinander, insbesondere des Abstandes dieser Nebenmaxima, und/oder der Lage eines der Maxima, insbesondere eines der genannten Nebenmaxima, im Koordinatensystem der Fouriertransformierten kann somit eine Defokussierung dem Betrag und dem Vorzeichen nach präzise festgestellt werden.

Unter Fokusposition versteht man die relative Lage des Objektivs zur angetasteten Grenzfläche. Die Defokussierung wird mit dem Vorzeichen "+" oder "-" beschrieben. Das Vorzeichen bezeichnet die Veränderung der Fokusposition nach oben oder unten. Aufgrund der hohen Geschwindigkeit der an sich bekannten Methode der Fast-Fouriertransformation (FFT) steht eine schnelle Auswertemethode zur Verfügung.

Es hat sich als besonders vorteilhaft erwiesen, zur Auswertung die Lage eines dem Hauptmaximum benachbarten Nebenmaximums im Koordinatensystem der Fouriertransformierten heranzuziehen. Diese Koordinaten bilden beim Durchlaufen einer Defokussierung von oberhalb des Fokus, durch den Fokus hindurch bis zu einem Punkt unterhalb des Fokus, eine Gerade. Zum Zwecke der Kalibrierung kann diese Gerade vor Beginn der mikroskopischen Untersuchung erzeugt werden. Die Kalibrierkurve dient anschließend während der mikroskopischen Untersuchung als Steuerkurve für die Autofokussierung. Da lineare Zusammenhänge vorliegen und die Gerade ausreichend Steigung besitzt, eignet sich diese besonders als Steuerkurve für die Autofokussierung.

Der Phasenwinkel, also das Wandern der Interferenzstreifen, erlaubt - wie bereits oben ausgeführt - insbesondere eine Feineinstellung der Fokuslage. Auch hier ergibt sich ein linearer Zusammenhang des Phasenwinkels abhängig von einer Defokussierung. Da die entsprechende Gerade hohe Steigung besitzt, handelt es sich um eine sehr sensitive Größe, die sich bei geringer Defokussierung stark ändert. Da jeweils nach Durchlaufen des Phasenwinkels von 0° bis 360° ein "Rücksprung" erfolgt, kann der Phasenwinkel nicht zur absoluten Bestimmung der Fokuslage herangezogen werden. Auch der Phasenwinkel kann anhand der Fouriertransformierten bestimmt werden. Für nähere Erläuterungen hierzu sei auf die Ausführungsbeispiele verwiesen.

Der Neigungswinkel der Interferenzstreifen steht zur Fokuslage nicht in linearem Zusammenhang; lediglich in einem kleinen Bereich um die Fokuslage herum kann der Zusammenhang mit einer Geraden approximiert werden. Außerhalb dieses Bereichs läuft der Neigungswinkel in eine Sättigung. Eine hohe Sensitivität dieser Auswertung ist somit nur in einem kleineren Bereich um den Fokus gegeben.

Die Erfindung betrifft weiterhin ein Computerprogramm und ein Computerprogrammprodukt mit Programmcode-Mitteln, um das erfindungsgemäße Autofokussierverfahren auszuführen. Das Computerprogramm ist zweckmäßigerweise in einer Autofokusauswerteeinheit eines weiter unten zu erläuternden erfindungsgemäßen Mikroskops abarbeitbar. Das Computerprogramm ist insbesondere auf die Schritte der Aufnahme und Auswertung des Interferenzmusters sowie die Ansteuerung einer Fokuseinstelleinrichtung abhängig vom Auswerteergebnis bezogen. Zweckmäßigerweise steuert das Computerprogramm den Fokus-Suchlauf sowie das anschließende Halten der zuvor eingestellten Fokusposition während einer mikroskopischen Untersuchung. Zum Halten des Fokus wird beispielsweise zwanzig mal pro Sekunde das aufgenommene Interferenzmuster ausgewertet und anhand der Ergebnisse entsprechend nachfokussiert. Da die Auswertung bevorzugt mittels Fouriertransformation erfolgt, bietet sich die Verwendung der Fast-Fouriertransformation (FFT) im Rahmen der Auswertung durch das Computerprogramm an, da diese sehr recheneffektiv und schnell vorgenommen werden kann.

Das Computerprogramm kann auf geeigneten Datenträgern wie EEPROMs, Flash-Momories, aber auch CD-ROMs, Disketten oder Festplattenlaufwerken gespeichert sein. Auch das Herunterladen des Computerprogramms über interne oder öffentlich nutzbare Netze ist möglich.

Die Erfindung betrifft neben dem oben ausführlich behandelten Verfahren auch ein entsprechendes Mikroskop mit einer Autofokuseinrichtung zur Einstellung des Fokus eines ein Mikroskopobjektiv enthaltenden Mikroskops. Ein solches Mikroskop weist eine Autofokusbeleuchtungsoptik zur Erzeugung eines Autofokusstrahlengangs auf. Weiterhin weist es ein auf der objektabgewandten Mikroskopobjektivseite angeordnete Umlenkeinrichtung zum Lenken des Autofokusstrahlengangs in Richtung Mikroskopobjektiv und von dort auf eine reflektierende Autofokus-Grenzfläche in einem Objektbereich und zum Lenken des an der Autofokus-Grenzfläche reflektierten und das Mikroskopobjektiv durchlaufenden Autofokusstrahlengangs in Richtung eines Autofokusdetektors auf, wobei die Umlenkeinrichtung zur Erzeugung interferierender Teilstrahlen des Autofokusstrahlengangs zwei in Ausbreitungsrichtung des Autofokusstrahlengangs zueinander beabstandete und den Autofokusstrahlengang jeweils reflektierende Bereiche aufweist. Weiterhin ist ein Autofokusdetektor zur Aufnahme eines Interferenzmusters in einer zur Mikroskopobjektivpupille konjugierten Ebene angeordnet. Zur Auswertung des aufgenommenen Interferenzmusters ist eine Autofokusauswerteeinheit in den Autofokusdetektor integriert oder steht mit diesem in Wirkverbindung. Schließlich steht eine Fokuseinstelleinrichtung zur Einstellung des Fokus des Mikroskops mit der Autofokusauswerteeinheit in Wirkverbindung.

Bezüglich der Funktionsweise der genannten Komponenten des erfindungsgemäßen Mikroskops mit Autofokuseinrichtung sei explizit auf die obigen Ausführungen im Zusammenhang mit dem erfindungsgemäßen Verfahren hingewiesen. Gleiches gilt für mögliche Ausgestaltungen.

Ergänzend sei noch erwähnt, dass die Fokuseinstelleinrichtung ausgestaltet ist, um zur Einstellung des Fokus des Mikroskops den Abstand des Mikroskopobjektivs von der Grenzfläche im Objektbereich zu verändern, wozu in der Regel die z-Position des Probentisches angesteuert wird, und/oder bei Einsatz eines Varioobjektivs als Mikroskopobjektiv die Brennweite des selbigen zu verändern.

Mit besonderem Vorteil ist die Autofokuseinrichtung bei einem inversen Mikroskop einsetzbar.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Die Erfindung ist anhand eines Ausführungsbeispieles in der Zeichnung schematisch dargestellt und wird im Folgenden unter Bezugnahme auf die Zeichnung ausführlich beschrieben.

Figurenbeschreibung

Figur 1     zeigt in schematischer Ansicht einen Prinzipstrahlengang einer Autofokuseinrichtung für ein Mikroskop gemäß Erfindung,

Figur 2     illustriert anhand eines Ausschnitts aus Figur 1 die Verhältnisse bei optimaler Fokuseinstellung und bei Defokussierung,

Figur 3     zeigt den Effekt der Verwendung einer Keilplatte als Umlenkeinrichtung,

Figur 4     veranschaulicht die Wahl geeigneter AutofokusGrenzflächen abhängig von Objektivtypen,

Figur 5     zeigt einen modifizierten Aufbau zur Erzeugung und Detektion eines Autofokusstrahlengangs in einem Mikroskop,

Figur 6     zeigt eine typische Anordnung von Interferenzmustern auf einer Detektorfläche,

Figur 7     zeigt die unterschiedlichen Interferenzstreifenmuster, wie sie bei Verwendung einer planparallelen Platte oder einer Keilplatte erhalten werden,

Figur 8     zeigt das typische Bild eines Interferenzstreifenmusters, wie es zur Auswertung herangezogen wird,

Figur 9     zeigt als exemplarische Beispiele zwei Streifenmuster und deren Fouriertransformierte und die hieraus abgeleitete Kalibrierkurve,

Figur 10     zeigt verschiedene Abbildungen von Fouriertransformationen von Interferenzstreifenmustern bei unterschiedlichen Fokusstellungen,

Figur 11     zeigt eine abgeleitete Fokus-Kennlinie zur Verwendung als Steuerkurve bei der Fokuseinstellung,

Figur 12     zeigt den Verlauf des Phasenwinkels eines Interferenzstreifenmusters abhängig von der Fokuslage,

Figur 13     zeigt die Neigung der Streifen im Interferenzstreifenmuster abhängig von der Fokuslage und

Figur 14     zeigt den Abstand des Hauptmaximums zu einem Nebenmaximum in der Fouriertransformierten eines Interferenzstreifenmusters abhängig von der Fokuslage.

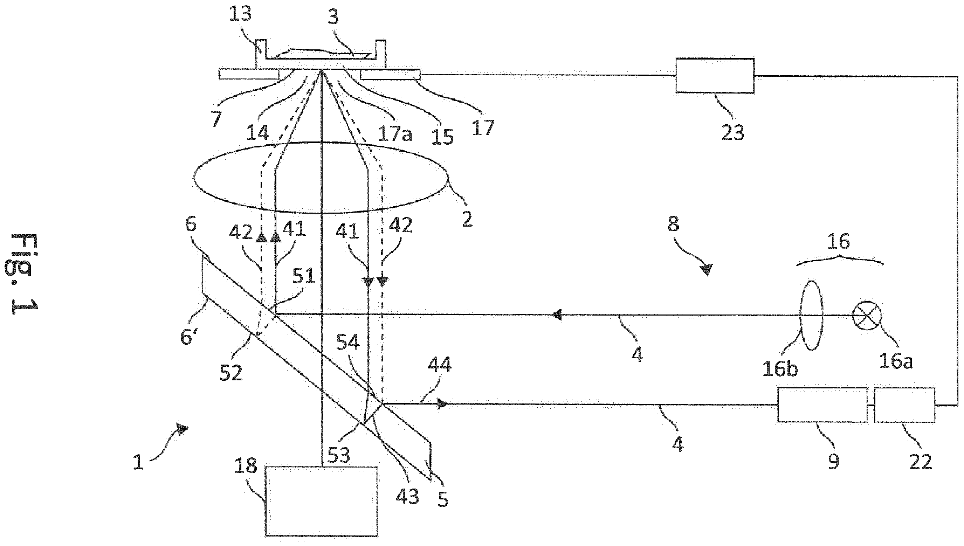

Figur 1 zeigt in schematischer Ansicht den Prinzipstrahlengang einer Autofokuseinrichtung 8 für ein Mikroskop 1, wobei von diesem Mikroskop 1 im wesentlichen nur das Mikroskopobjektiv 2 dargestellt ist. Alle weiteren Komponenten des Mikroskops 1 sind als Beobachtungsoptik 18 angedeutet. Die Beobachtungsoptik 18 umfasst bekannte Bestandteile eines Mikroskops, wie Vergrößerungswechsler oder Zoomsystem, Tubus und Okular. Zusätzlich zum oder anstelle eines Okulars kann eine Kamera zur Aufnahme des Mikroskopbildes vorgesehen sein. Das Mikroskopbild selbst kann beispielsweise auf einem Monitor dargestellt werden. Bei dem hier dargestellten Beispiel handelt es sich um inverses Mikroskop 1, wie es häufig für Untersuchungen im "Living Cell-Bereich" verwendet wird. Dort wird mit Zellproben, die in einer wässrigen Lösung eingebettet sind (Nährlösung), gearbeitet. Der Mikroskoptisch 17 besitzt eine Durchlichtöffnung 17a, über der eine Petrischale 13 mit dem zu untersuchenden Objekt 3 angeordnet ist. Bei dem Objekt 3 handelt es sich wie bereits gesagt beispielsweise um Zellproben in einer wässrigen Lösung. Die Bodendicke der Petrischale 13 beträgt typischerweise 0,17 mm. Die Untersuchung der Proben erfolgt mittels mikroskopischer Kontrastierverfahren, zum Beispiel Fluoreszenz oder DIC (differentieller Interferenzkontrast). Um Zelldetails auflösen zu können, werden fast ausschließlich hoch vergrößernde Immersionsobjektive ab einer Vergrößerung von 20x (z.B. 63x/1.20 Wasser oder 100x/1.40 Öl) verwendet. Der Benutzer sucht sich eine für ihn interessante Präparatstelle meist visuell aus und möchte diese über einen längeren Zeitraum, beispielsweise bei einem Langzeitexperiment mit Manipulation der Zellproben, beobachten. Hierzu werden in aller Regel Mikroskopaufnahmen des interessierenden Probenbereichs mit einer Digitalkamera erstellt. Aufgrund thermischer Einflüsse oder Vibrationen kann sich der optische Abstand zwischen dem beobachteten Bereich und dem Mikroskopobjektiv 2 ändern. Es ist auch möglich, dass es sich bei der Probe um lebende Zellen handelt, die ihre Ausdehnung oder Lage z.B. infolge Zellteilung verändern. Für eine sinnvolle Auswertung der Mikroskopaufnahmen ist es jedoch von enormer Wichtigkeit, den Abstand zwischen Mikroskopobjektiv 2 und dem interessierenden Bereich unverändert zu halten, um Mikroskopaufnahmen gleichbleibender Qualität zu erhalten. Diesem Zweck dient eine Autofokuseinrichtung 8, die im hier betrachteten Ausführungsbeispiel mit einem "Offset" arbeitet, indem der Autofokus auf eine besser antastbare Grenzfläche eingestellt wird als der visuelle Fokus, der auf dem zu untersuchenden interessierenden Bereich liegt. Im betrachteten Fall wird die Grenzfläche 7 zwischen der objektabgewandten Seite des Petrischalenbodens 15 und der unterhalb des Bodens befindlichen Luft 14 als Autofokus-Grenzfläche 7 verwendet. Der visuelle Fokus liegt dann um 0,17 mm (Bodendicke der Petrischale 13) von dieser Autofokus-Grenzfläche 7 verschoben.

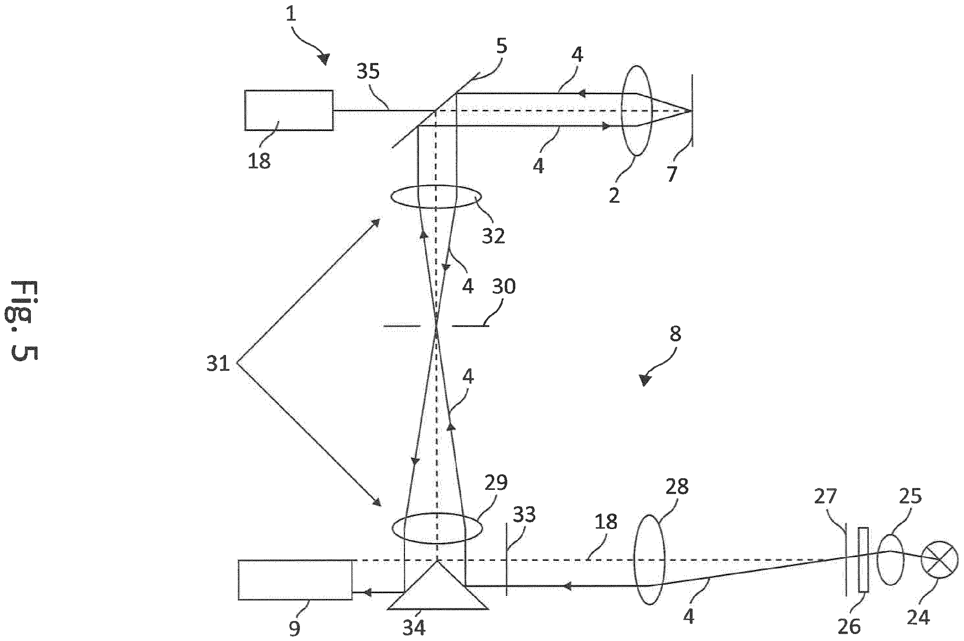

Die hier behandelte Autofokuseinrichtung 8 erzeugt mittels einer Autofokusbeleuchtungsoptik 16 einen Autofokusstrahlengang 4. Als Lichtquelle 16a dient insbesondere eine LED-Lichtquelle im Spektralbereich des nahen Infrarot (z.B. 750 nm bis 900 nm). Alternativ kann eine Weißlichtquelle mit einem monochromen Filter verwendet werden. Eine Optik, hier als Beleuchtungslinse 16b schematisch dargestellt, erzeugt den Autofokusstrahlengang 4 (vgl. hierzu auch die Erläuterungen zu Figur 5). Dieser Autofokusstrahlengang 4 wird mittels einer Umlenkeinrichtung 5 in den Mikroskopstrahlengang eingekoppelt. Die Umlenkeinrichtung 5 befindet sich zwischen Mikroskopobjektiv 2 und Beobachtungsoptik 18, insbesondere der Tubuslinse der Beobachtungsoptik 18. Da der Autofokus im nahen Infrarot realisiert ist, stört er weder das Arbeiten im visuellen Spektralbereich (etwa 400 nm bis 700 nm), noch die Untersuchung bei Fluoreszenzbeleuchtung im nahen UV-Bereich (etwa 340 nm bis 450 nm). Der Autofokusstrahlengang 4 durchläuft das Objektiv 2 und wird an der Autofokusgrenzfläche 7 reflektiert, woraufhin er nochmals das Objektiv 2 durchläuft und wiederum an der Umlenkeinrichtung 5 reflektiert wird, um in einer zur Objektivpupille konjugierten Ebene auf dem Autofokusdetektor 9 empfangen zu werden.

Im Folgenden soll der Verlauf des Autofokusstrahlengangs 4 bei seinen Reflexionen an der Umlenkeinrichtung 5 näher betrachtet werden: Zunächst wird, wie aus Figur 1 ersichtlich, der Autofokusstrahlengang 4 zum Teil im Bereich 51 reflektiert. Durch diese Reflexion entsteht der Teilstrahl 41. Hinter dem Bereich 51 ist ein weiterer beabstandeter Bereich 52 vorhanden, der seinerseits reflektierend auf den Teilstrahl wirkt, der den Bereich 51 passiert hat. Die Reflexion am Bereich 52 der Umlenkeinrichtung 5 führt zu einem Teilstrahl 42, der aus der Umlenkeinrichtung 5 austritt und in Richtung Mikroskopobjektiv 2 läuft. Weitere Reflexionen und Teilstrahlen seien im Folgenden nicht betrachtet, da sie für das Verständnis des hier vorgestellten Autofokusprinzips nicht wesentlich sind.

Nach Durchlaufen des Objektivs 2 und Reflexion an der Autofokus-Grenzfläche 7 breiten sich die Teilstrahlen 41 und 42 wiederum in Richtung Umlenkeinrichtung 5 aus, um dort auf die in Ausbreitungsrichtung des Autofokusstrahlengangs hintereinander angeordneten, zueinander beabstandeten Bereichen 54 und 53 zu treffen. Es sei in diesem Zusammenhang betont, dass unter "Autofokusstrahlengang" immer auch die erzeugten Teilstrahlen umfasst sein sollen, sofern diese nicht explizit als solche benannt sind. Der erste vordere Teilstrahl 41 wird zum Teil am vorderen Bereich 54 reflektiert (nicht dargestellt) und zum anderen Teil am hinteren Bereich 53, woraus sich ein Teilstrahl 43 ergibt, der wiederum aus der Umlenkeinrichtung 5 austritt (Mehrfachreflexionen seien hier abermals nicht betrachtet). Der erste hintere Teilstrahl 42 wird zum Teil am vorderen Bereich 54 der Umlenkeinrichtung 5 reflektiert. Der hier reflektierte Teilstrahl überlagert sich mit Teilstrahl 43 zu einem Teilstrahl 44. Weitere Reflexionen des Teilstrahls 42 seien hier nicht betrachtet, da sie für das Verständnis nicht erforderlich sind. Teilstrahl 44 enthält somit den am hinteren Bereich der Umlenkeinrichtung 5 reflektierten Teilstrahl 43 des ersten vorderen Teilstrahls 41 und den am vorderen Bereich der Umlenkeinrichtung 5 reflektierten Teilstrahl des ersten hinteren Teilstrahls 42. Dieser Teilstrahl 44 ist geeignet, ein Interferenzmuster zu erzeugen, wenn die beiden besagten Teilstrahlen, die den Teilstrahl 44 bilden, eine optische Weglängendifferenz aufweisen. Das entsprechende Interferenzmuster entsteht auf der Detektorfläche im "Bereich 2", wie er oben in der Beschreibung definiert wurde. Der "Bereich 1" wird von Teilstrahlen gebildet, die jeweils an den vorderen Bereichen 51 und 54 reflektiert wurden. Es ergibt sich in diesem Bereich ein gleichmäßig ausgeleuchteter Abschnitt auf der Detektorfläche. Weitere Bereiche ("Bereich 3" etc.) zeigen ebenfalls Interferenzmuster, die jedoch licht- und kontrastärmer sind und daher für die hier geschilderte Auswertung nicht herangezogen werden.

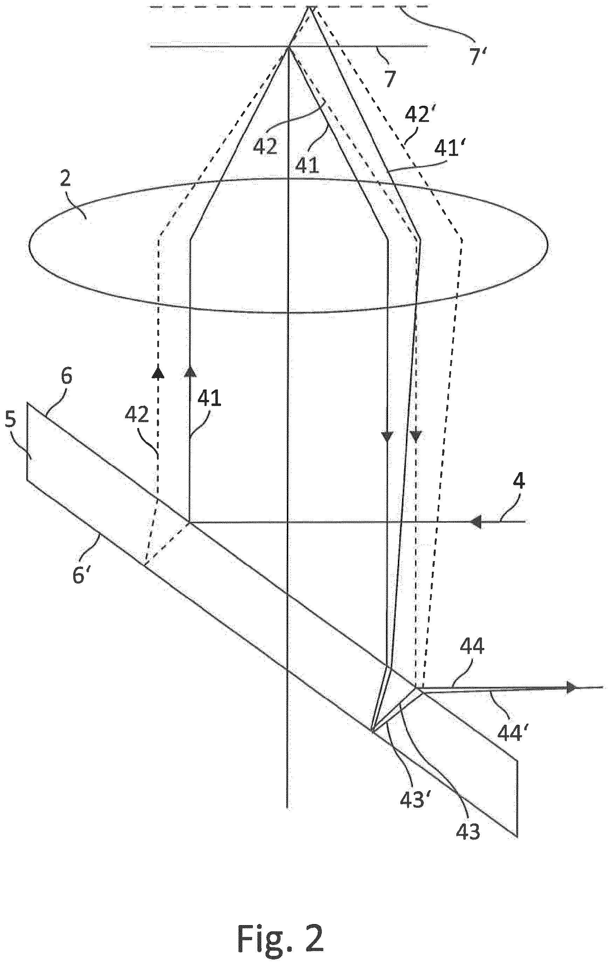

Bei dem in Figur 1 dargestellten Fall der optimalen Fokuseinstellung ergibt die Überlagerung der den Teilstrahl 44 bildenden Teilstrahlen ebenfalls ein gleichmäßig ausgeleuchteten Abschnitt im Bereich 2 der Detektorfläche, da es erst bei Defokussierung zu einem Unterschied der optischen Weglängen kommt. Dieser Fall sei anhand Figur 2 erläutert.

Wie in Figur 1 dargestellt, lässt sich eine Anordnung der Bereiche 51, 52 und 53, 54 zur Erzeugung der Autofokus-Teilstrahlen in der Praxis durch einen dichroitischen Teiler mit Begrenzungsflächen 6 und 6' verwirklichen. Die Begrenzungsfläche 6 wirkt für den Autofokusstrahlengang 4 wenigstens zum Teil reflektierend, gleiches gilt für die Grenzfläche 6'. Hingegen ist der dichroitische Teiler für andere Spektralbereiche durchlässig, so dass die oben genannten Mikroskopierverfahren ohne Intensitätsverlust durchführbar sind.

Dem Detektor 9 nachgeschaltet ist eine AutofokusAuswerteeinheit 22, in der das vom Detektor 9 aufgenommene Interferenzmuster ausgewertet wird, wie nachfolgend detailliert beschrieben werden wird. Abhängig von der Auswertung wird ein Signal erzeugt, das an die Fokuseinstelleinrichtung 23 gegeben wird, um eine etwaige Defokussierung rückgängig machen zu können. Hierzu steuert die Fokuseinstelleinrichtung 23 in dem in Figur 1 dargestellten Fall den Mikroskoptisch 17 an. Die Ansteuerung verläuft derart, dass der z-Trieb des Mikroskoptisches 17 angesteuert wird, der wiederum den Mikroskoptisch 17 in z-Richtung (Richtung der Hauptachse des Objektivs 2) verschiebt. Es ist vorteilhaft, die Fokuseinstellung als Regelkreis zu realisieren, um fortlaufend Abweichungen von der optimalen Fokuseinstellung auf Null regeln zu können.

Figur 2 zeigt einen Ausschnitt aus Figur 1, um den Verlauf des Autofokusstrahlengangs 4 zwischen Umlenkeinrichtung 5 und Autofokusgrenzfläche 7 im Falle der optimalen Fokuseinstellung und im Falle einer Defokussierung zu verdeutlichen. Figur 2 zeigt zum einen den Strahlenverlauf bei optimaler Fokuseinstellung, wenn der Fokus der Autofokuseinrichtung auf die Autofokus-Grenzfläche 7 gestellt ist. Für diesen Fall wird auf die Erläuterungen der Figur 1 verwiesen. Parallel hierzu zeigt Figur 2 den Strahlenverlauf bei Defokussierung, also der Fall einer Verschiebung der Autofokus-Grenzfläche 7 in die Grenzfläche 7', beispielsweise aufgrund einer Vibration oder einer thermischen Drift. Die an der Grenzfläche 7' reflektierten Teilstrahlen 41 und 42 sind in Figur 2 als 41' bzw. 42' bezeichnet. Sie gelangen unter einem lateralen Versatz in das Objektiv 2 und von dort auf die Umlenkeinrichtung 5. Der im Objektivbereich noch vorhandene laterale Versatz zwischen den Strahlengängen 44 und 44' ist an der Detektorfläche nicht mehr vorhanden, weil der Detektor 9 in einer zur Objektivpupille konjugierten Ebene angeordnet ist. Der bei Defokussierung erzeugte Teilstrahl 44' ist zusammengesetzt aus dem Teilstrahl 43', der durch Reflexion im hinteren Bereich der Umlenkeinrichtung 5 aus dem ersten vorderen Teilstrahl 41' entsteht, und dem am vorderen Bereich der Umlenkeinrichtung 5 reflektierten ersten hinteren Teilstrahl 42'. Aus Figur 2 ist ersichtlich, dass die symmetrischen Verhältnisse, die bei optimaler Fokuseinstellung existieren, im Falle der Defokussierung aufgehoben sind, so dass diejenigen Teilstrahlen, die sich zum Teilstrahl 44' zusammensetzen, eine optische Weglängendifferenz aufweisen. In der Folge entsteht ein Interferenzstreifenmuster. Dieses Interferenzstreifenmuster ist insbesondere im Bereich 2 der Detektorfläche, wie er bereits oben beschrieben worden ist, am deutlichsten erkennbar und detektierbar.

Wie an anderer Stelle der Beschreibung bereits ausführlich erläutert, ist es vorteilhaft, auch im Falle der optimalen Fokuseinstellung eine "Grundinterferenz" zu erzeugen. Ausgehend von dieser Grundinterferenz lässt sich eine Defokussierung schnell und eindeutig dadurch detektieren, dass Charakteristika des Grundinterferenzstreifenmusters sich ändern. Eines solche "Grundinterferenz" kann beispielsweise mittels eines Keilwinkels im dichroitischen Teiler, etwa durch Verwendung einer Keilplatte, erzeugt werden.

In einer ersten Ausgestaltung sei angenommen, dass ausgehend von der Darstellung in Figur 1 die beiden Begrenzungsflächen 6 und 6' einen Keilwinkel miteinander einschließen, wobei der Keilwinkel eine Ebene aufspannt (hier die Zeichenebene), in der der hinlaufende und der zurücklaufende Autofokusstrahlengang 4 liegt. In einem solchen Fall, der sich anhand der Darstellung in Figur 1 leicht veranschaulichen lässt, hätten die den Teilstrahl 44 bildenden Teilstrahlen auch im Fall der optimalen Fokuseinstellung unterschiedliche optische Weglängen zu durchlaufen, so dass ein Interferenzstreifenmuster am Detektor 9 die Folge wäre. Eine Defokussierung in eine Richtung (beispielsweise in eine Richtung vom Objektiv 2 weg) kann diesen optischen Weglängenunterschied verstärken, während eine Defokussierung in die andere Richtung (beispielsweise zum Objektiv 2 hin) die in der Fokuseinstellung vorhandene optische Weglängendifferenz kompensieren kann. Im Falle der Kompensation würde auf dem Detektor das Interferenzstreifenmuster verschwinden und eine gleichmäßige Ausleuchtung zu sehen sein.

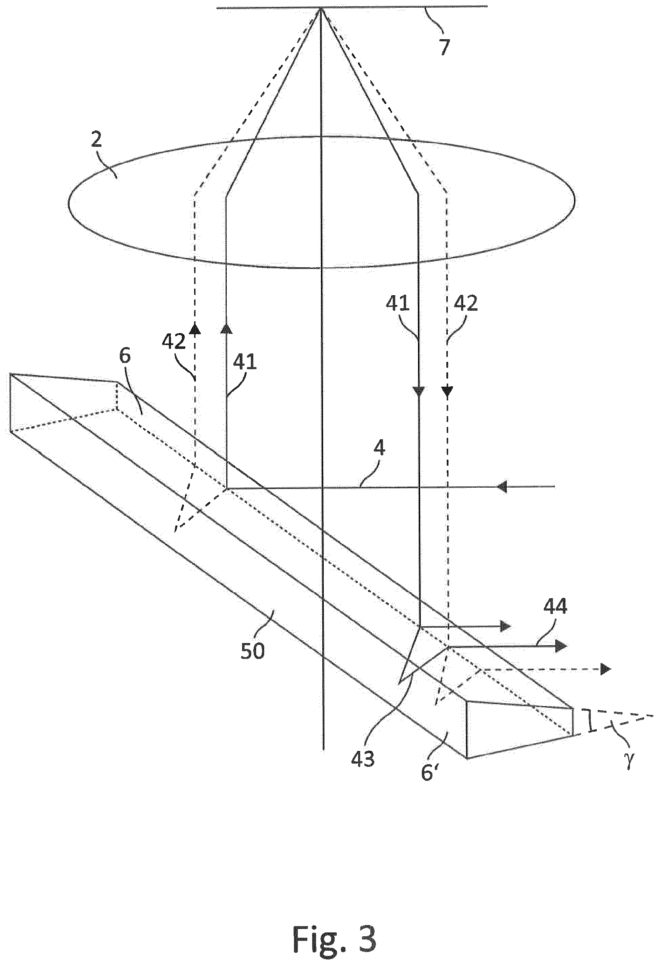

In einer zweiten Ausführungsform wird eine Keilplatte als Umlenkeinrichtung 5 verwendet, bei der der Keilwinkel eine Ebene aufspannt, die senkrecht auf die Zeichenebene der Figur 1, also senkrecht auf die Ebene steht, in der der hinlaufende und der zurücklaufende Autofokusstrahlengang 4 liegen. Dieser Fall ist in Figur 3 dargestellt. Es lässt sich feststellen, dass der in Figur 3 dargestellte Aufbau zu einer Drehung der Neigung der Interferenzstreifen um 90 Grad führt. Unterstellt man, dass bei einem Aufbau gemäß Figur 1 im Falle einer Defokussierung Interferenzstreifen auf der Detektorfläche entstehen, die im wesentlichen waagrecht verlaufen, so stellt man bei einem Aufbau gemäß Figur 3 fest, dass es zu einer "Grundinterferenz" kommt, bei der die Interferenzstreifen senkrecht verlaufen. Die hier beschriebenen Ausrichtungen der Interferenzstreifen dienen selbstverständlich lediglich der besseren Anschauung des Effekts der Verwendung einer Keilplatte als Umlenkeinrichtung 5. Durch entsprechende andere Orientierung des Keilwinkels zwischen den Begrenzungsflächen 6 und 6' lässt sich folglich auch die Neigung der Interferenzstreifen des "Grundinterferenzmusters" beeinflussen und für Auswertezwecke optimal einstellen.

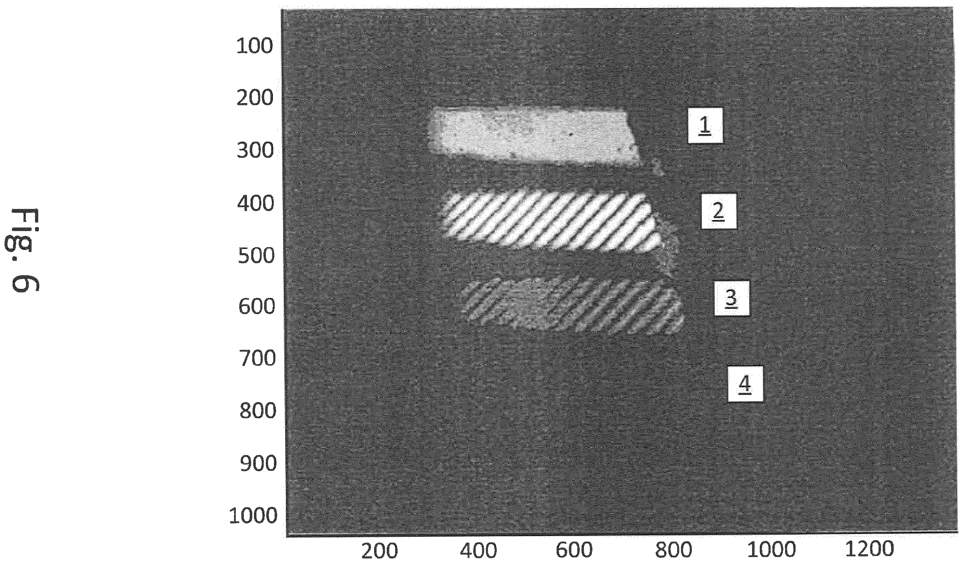

Figur 3 zeigt die Verwendung einer bevorzugten Keilplatte 50 als Umlenkeinrichtung 5 mit ihren Begrenzungsflächen 6 und 6'. Gleiche Komponenten und Strahlengänge wie die in Figur 1 oder 2 sind auch hier wieder mit denselben Bezugszeichen bezeichnet. Wiederum ist der Teilstrahl 44 in Figur 3 bezeichnet, der zu einem Interferenzmuster führt, das zur Fokuseinstellung optimal herangezogen werden kann. Das entsprechende Interferenzmuster entsteht im "Bereich 2" auf der Detektorfläche (vgl. auch Figur 6). Der rechts vom Teilstrahl 44 verlaufende Teilstrahl enthält nur an den vorderen Bereichen der Umlenkeinrichtung 5, also an der vorderen Begrenzungsfläche 6 reflektierte Strahlen und führt zu einem gleichmäßig ausgeleuchteten Abschnitt im "Bereich 1" der Detektorfläche. Auf der linken Seite des Teilstrahls 44 ist gestrichelt ein weiterer Teilstrahl in Figur 3 eingezeichnet, der sich aus Reflexion des Teilstrahls 42 am hinteren Bereich der Umlenkeinrichtung 5, also an der hinteren Begrenzungsfläche 6' ergibt. Solche durch Mehrfachreflexionen entstandenen Teilstrahlen ergeben weitere Bereiche auf der Detektorfläche, die jedoch licht- und kontrastärmer sind.

Der Detektor, üblicherweise eine ortsauflösende CCD-Kamera ist in einer zur Objektivpupille konjugierten Ebene angeordnet. Besagte "Bereiche" auf der Detektorfläche weisen einen Pupillenversatz von 0,75x Plattendicke auf, wenn man von einer Planparallelplatte ausgeht, die unter einem Umlenkwinkel von 45 Grad angeordnet ist. Die Höhe der jeweiligen Bereiche entspricht der Spaltbreite des Spalts, der zur Erzeugung des Autofokusstrahlengangs eingesetzt wird.

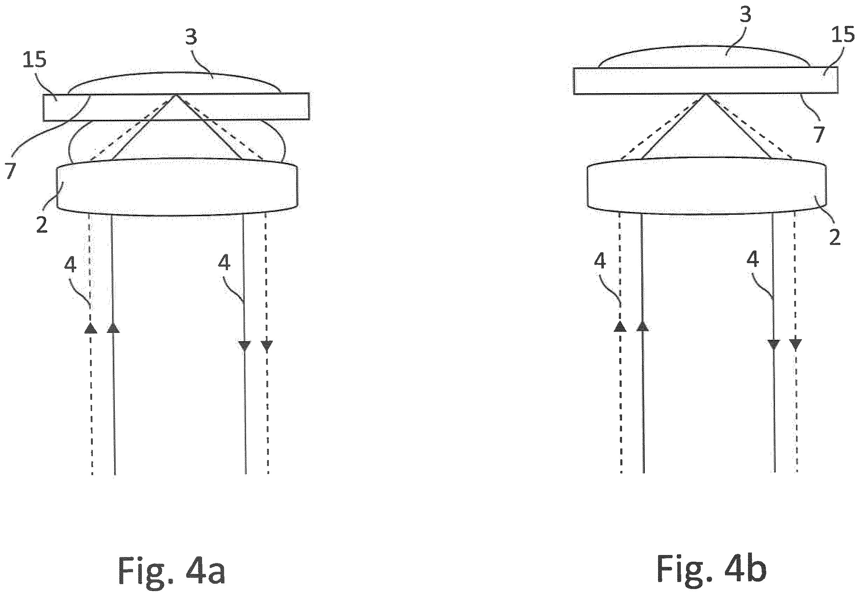

Figur 4 veranschaulicht die Wahl einer geeigneten Autofokus-Grenzfläche 7 bei zwei verschiedenen Objektivtypen. Figur 4a zeigt ein Immersionsobjektiv, bei dem sich in dem Bereich zwischen Objektiv 2 und Boden 15 der Petrischale ein Immersionsmittel (Öl) befindet. Als Autofokus-Grenzfläche 7 wird hier zweckmäßigerweise die Grenzfläche zwischen Boden 15 der Petrischale und angrenzender Probe 3 verwendet, da diese Grenzfläche den Autofokusstrahlengang 4 besser reflektiert. Figur 4b zeigt die Verhältnisse bei einem Trockenobjektiv 2 und die Wahl der Autofokus-Grenzfläche 7 entsprechend Figur 1.

Figur 5 zeigt einen modifizierten Aufbau des Strahlverlaufs einer Autofokuseinrichtung 8 in einem Mikroskop 1.

Ausgehend von einer Weißlichtquelle 24 mit vorgeschaltetem Kollektor 25 und Spektralfilter 26 wird mittels einer Blende 27 ein Beleuchtungsspot erzeugt. Die Beleuchtungsoptik 28 bildet zusammen mit der Fokussierlinse 29 den Beleuchtungsspot in die Leuchtfeldblende 30 ab. Über die sogenannte Transportoptik 31, die die entlang der optischen Achse verschiebbare Fokussierlinse 29 und eine weitere Transportlinse 32 umfasst, wird der Autofokusstrahlengang 4 zum Objektiv 2 des Mikroskops 1 geleitet. Ein dichroitischer Strahlteiler 5 teilt den zum Tubus der Beobachtungsoptik 18 führenden Abbildungsstrahlengang 35 des Mikroskops 1 von dem hier dargestellten Strahlengang 4 der Autofokuseinrichtung 8 ab. Der Autofokusstrahlengang 4 erreicht die Autofokus-Grenzfläche 7, an der er reflektiert wird.

Wie aus Figur 5 ersichtlich, erzeugt die Autofokus-Aperturblende 33 einen Autofokusstrahlengang 4 in der einen Hälfte des Querschnitts eines entlang der optischen Achse 18 verlaufenden Strahlenbündels, wobei der Autofokusstrahlengang 4 dezentriert von der optischen Achse 18 verläuft.

Der remittierte, d. h. von der Grenzfläche 7 reflektierte Autofokusstrahlengang 4 gelangt, wie in Figur 5 schematisch dargestellt, seinerseits wiederum über den Strahlteiler 5 und die Transportoptik 31 zum Umlenkprisma 34. Durch das Umlenkprisma 34 wird der Autofokusstrahlengang 4 zu einer der Beleuchtungsseite gegenüberliegenden Detektorseite der Autofokuseinrichtung 8 reflektiert. Der Detektor 9 ist in einer zur Objektivpupille konjugierten Ebene angeordnet und beispielsweise als zweidimensionale CCD-Kamera ausgebildet.

Zu jedem verwendeten Objektiv 2 können in der Ansteuereinrichtung der Autofokuseinrichtung die technischen Daten, wie Vergrößerung, Trocken- oder Nass-Objektiv, numerische Apertur, hinterlegt werden. Dazu kommen bei Bedarf noch Bereichsangaben über zulässige z-Werte, d.h. den Abstand, des Objektivs 2 relativ zum Präparat 3. Dies verhindert unbeabsichtes Aufsetzen der Frontlinse des Objektivs 2 auf das Präparat 3, wodurch sie beschädigt werden kann. Außerdem wird in der Ansteuereinrichtung der Autofokuseinrichtung für die geplanten Untersuchungen hinterlegt, welche Dicke die verwendeten Deckgläser oder Petrischalenböden haben. Da in der Regel die Pupillenlage eines Objektivs vom jeweils verwendeten Objektiv 2 abhängt, ist die Fokussierlinse 29 entlang der optischen Achse verschiebbar gelagert, um die jeweilige Objektivpupillenlage optimal auf den Detektor 9 abbilden zu können. Hierdurch wird eine Verschiebung des Detektors beim Wechsel des Objektivs 2 vermieden.

Beispielsweise kann beim aufrechten Mikroskop als Position des Antast-Fokus auf der Autofokus-Grenzfläche 7 die dem Objekt abgewandte Seite eines Deckglases gewählt werden (Deckglasdicke beträgt ungefähr 170 pm), während der visuelle Fokus des Mikroskops unterhalb des Deckglases, also auf besagter Grenzfläche, liegt. Dies hat den Vorteil, dass der Autofokusstrahlengang 4 auf eine Glas-Luftfläche als Autofokus-Grenzfläche 7 gerichtet ist, wo er einen stärkeren Reflex erhält, und somit stärkere Fokussignale mit besserem Regelverhalten erzeugt werden. Nach (automatischer oder visueller) Einstellung des visuellen Fokus wird das entsprechende Interferenzmuster, das durch Reflexion des Autofokusstrahlengangs 4 an der Autofokusgrenzfläche 7 und der beschriebenen nachfolgenden Interferenz der Autofokus-Teilstrahlen entsteht, aufgenommen und als Referenzinterferenzmuster hinterlegt oder gespeichert. Insbesondere werden die beschriebenen Charakteristika oder die entsprechenden Informationen aus der Fouriertransformation des Interferenzmusters gespeichert. Dieses Referenzinterferenzmuster dient zur optimalen Fokuseinstellung und somit als Sollwert einer nachfolgenden Regelung der Fokuseinstellung.

Anschließend erfolgt die mikroskopische Untersuchung, während derer der Antast-Fokus mittels der Autofokuseinrichtung 8 konstant gehalten wird, wodurch auch sichergestellt ist, dass der visuelle Fokus unverändert bleibt.

Figur 6 zeigt typische Interferenzmuster, wie sie bei dem oben beschriebenen Aufbau einer Autofokuseinrichtung 8 mit einer Keilplatte 50 mit einem Keilwinkel von 1' und einem 20x/0.70-Objektiv 2 in der Objektivpupille entstehen. Die hier als Autofokusdetektor 9 verwendete CCD-Kamera hat eine Auflösung von 1040 x 1392 Pixel. Die Achsenbeschriftung der Figur 6 entspricht der Pixelzahl. Die unterschiedlichen Bereiche sind mit weiß unterlegten Ziffern "1", "2", "3" und "4" kenntlich gemacht, wobei "Bereich 1" sich aus Reflexionen ergibt, die jeweils von der Vorderfläche der Keilplatte 50 stammen. Hier ist kein Interferenzstreifenmuster zu erwarten. Der "Bereich 2" stellt die beschriebenen Interferenzen dar, wie sie durch den Teilstrahl 44 (vgl. Figur 1) erzeugt werden. Im "Bereich 3" und ansatzweise im "Bereich 4" sind die bereits erwähnten Interferenzen höherer Ordnung zu erkennen, die deutlich lichtschwächer sind. Deutlich sichtbar ist, dass die Interferenzstreifen, also die Helligkeitsmaxima sowie die Helligkeitsminima, eine bestimmte Streifendichte bei einer bestimmten Streifenneigung (bezogen auf eine willkürlich gewählte Achse) besitzen. Ausgehend von dieser Momentaufnahme beobachtet man ein Wandern der Streifen bei Zunahme der Defokussierung, wobei beispielsweise ein heller Streifen an die Stelle seines Nachbarn wandert. Kommt ein heller Streifen auf diese Weise an der Stelle des ursprünglich benachbarten hellen Streifens zu liegen, wurde ein Phasenwinkel von 360 Grad ($2\pi$) durchwandert.

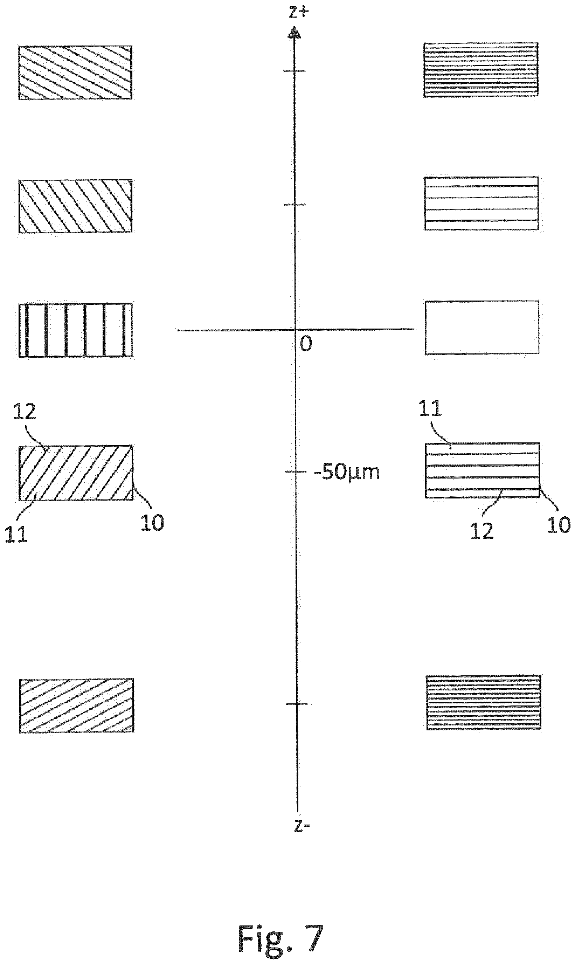

Figur 7 zeigt sehr schematisch das Verhalten des Interferenzstreifenmusters bei einer Defokussierung und den Einfluss eines Keilwinkels. Auf der rechten Seite der Figur 7 sind Interferenzbilder (im folgenden sind hiermit immer Interferenzmuster aus dem "Bereich 2" auf der Detektorfläche gemeint) dargestellt, wie sie mit einer Umlenkeinrichtung erhalten werden, die planparallele Begrenzungsflächen 6, 6' (vgl. Figur 1) aufweist, also beispielsweise ein planparalleler Teiler. Auf der linken Seite der Figur 7 ist hingegen ein Interferenzmuster dargestellt, wie es bei Verwendung einer Keilplatte 50 als Umlenkeinrichtung 5 erhalten wird. Die z-Achse liegt parallel zur Hauptachse des Objektivs 2; ihr Nullpunkt entspricht der Fokuslage.

Bei Verwendung einer planparallelen Platte (rechte Seite der Figur 7) ergibt sich - wie bereits ausführlich beschrieben - in der Fokuslage ein gleichmäßig ausgeleuchteter "Bereich 2". Bei einer Defokussierung in positiver Richtung der z-Achse ergibt sich ein waagrechtes Interferenzstreifenmuster, dessen Dichte bei weiterer Defokussierung zunimmt.Ein ähnliches Verhalten der Interferenzstreifen ergibt sich bei einer Defokussierung in negativer Richtung der z-Achse.

Bei Verwendung einer Keilplatte erhält man in der Fokusposition (z=0) eine typische "Grundinterferenz", nämlich in diesem Fall ein in senkrechter Richtung verlaufendes Interferenzstreifenmuster. Die Ausrichtung des Keilwinkels entspricht hierbei der Situation in Figur 3. Es zeigt sich eine Drehung der Interferenzstreifen um 90 Grad gegenüber der Situation ohne Keilwinkel. Bei einer Defokussierung in positiver Richtung der z-Achse beobachtet man eine Neigung der Interferenzstreifen in positiver Winkelrichtung (ausgehend von der senkrechten Richtung der Streifen in der Fokuslage). Bei weiterer Defokussierung in positiver Richtung der z-Achse nimmt der Neigungswinkel noch zu, und die Interferenzstreifen nähern sich einem waagrechten Verlauf. Gleichzeitig nimmt auch die Dichte der Interferenzstreifen zu. Ähnliche Verhältnisse liegen bei einer Defokussierung in negativer Richtung der z-Achse vor. Allerdings neigen sich die Streifen nun in andere Richtung (negativer Neigungswinkel bezogen auf die Senkrechte). Auch die Streifendichte wird mit zunehmender Defokussierung höher.

Prinzipiell stehen zur Autofokussierung beide dargestellte Möglichkeiten (mit und ohne Keil) zur Verfügung. Schließlich lässt sich der Keilwinkel auch anders orientieren, so dass das Streifenmuster "Grundinterferenz" (bei z=0) eine vorgebbare Ausrichtung besitzen kann. Andererseits zeigt Figur 7 deutlich, dass die Auswertung mit Keilwinkel zuverlässiger zu realisieren ist, da die "Grundinterferenz" als Bezugspunkt gilt und Abweichungen von dieser Grundinterferenz klar und deutlich detektierbar sind. Auch die Richtung der Defokussierung lässt sich leicht feststellen. Einzelheiten zur Auswertung werden weiter unten beschrieben.

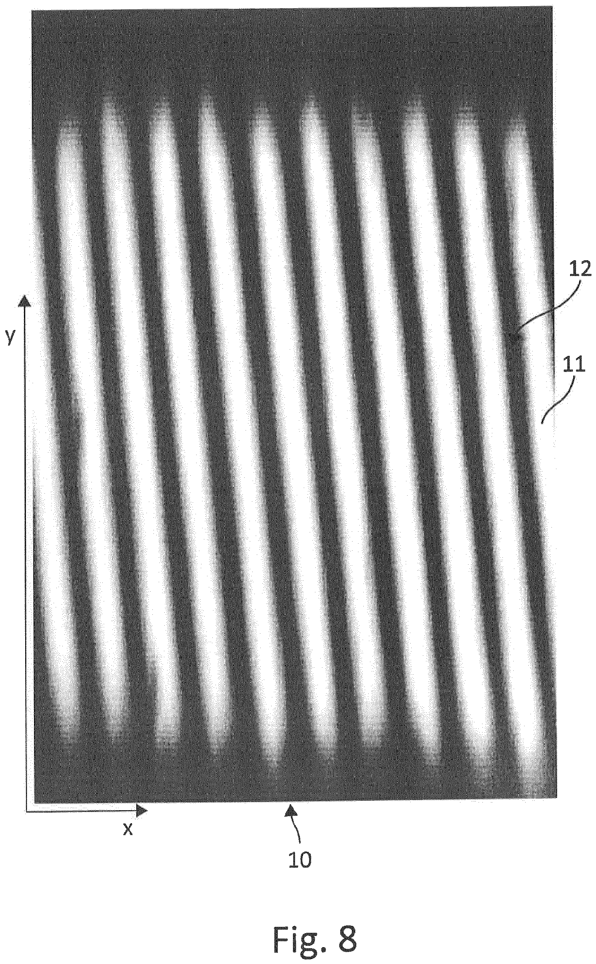

Figur 8 zeigt nochmals anschaulich in vergrößerter Form ein typisches Interferenzstreifenmuster auf der Detektoroberfläche ("Bereich 2"), wie es zu Auswertung herangezogen wird.

Bevor die verschiedenen Möglichkeiten der Auswertung im Einzelnen näher erläutert werden, soll ein Einblick in die Grundlagen der Fourieranalyse gegeben werden. Die Fourieranalyse bietet die Möglichkeit, optische Vorgänge anhand von Raumfrequenzen zu betrachten. Mit einer Fouriertransformation kann die Ortsdarstellung, die sich auf die Parameter Raum und Zeit bezieht, in eine räumliche Frequenzdarstellung transformiert werden. Tatsächlich kann jede Funktion im Ortsraum als Überlagerung von Sinus- und Kosinusfunktionen verschiedener Ortsfrequenzen dargestellt werden. In einfachen Worten ausgedrückt kann eine Anordnung von Streifen mit einer bestimmten Dichte als eine periodische Funktion im Ortsraum aufgefasst werden. Die Fouriertransformation transformiert diese periodische Struktur in den Ortsfrequenzraum und zeigt dort Maxima bei all den Ortsfrequenzen, die in besagter periodischer Struktur vorhanden sind.

Da ein Interferenzstreifenmuster ein zweidimensionales Intensitätsprofil auf der Detektorfläche darstellt, kommt zur Auswertung die zweidimensionale Fouriertransformation zur Anwendung. Während die eindimensionale Fouriertransformation eine Zerlegung des Eingangssignals in einen Kosinus- und Sinusanteil bedeutet, kann man sich die zweidimensionale Fouriertransformation als eine Zerlegung des Eingangssignals in ebene Wellen vorstellen. Wenn f(x, y) die zweidimensionale (periodische) Funktion beispielsweise des Interferenzstreifenmusters darstellt, mit x und y als Koordinaten im Ortsraum, so bezeichnet $F(k_x, k_y)$ die zugehörige Fouriertransformierte im Ortsfrequenzraum mit den Koordinaten $k_x$ und $k_y$ als jeweilige Ortskreisfrequenzen in x- und y-Richtung. Es besteht folgender Zusammenhang

$$f(x, y) = \frac{1}{(2\pi)^2} \int^{+\infty} \int_{-\infty} F(k_x, k_y) e^{-i(k_x x + k_y y)} dk_x dk_y$$

$$F(k_x, k_y) = \int^{+\infty} \int_{-\infty} f(x, y) e^{i(k_x x + k_y y)} dx dy$$

Beispielsweise enthält die Fouriertransformierte einer Sinusfunktion im Ortsraum (vergleichbar mit der Funktion eines Interferenzstreifenmusters in einer Richtung senkrecht zu den Streifen) unter anderem die Ortsfrequenz sowie die Phase. Aufgrund der Symmetrie der Fouriertransformierten sind die Ortsfrequenzen symmetrisch zur Ortsfrequenz Null im positiven wie im negativen Frequenzraum angeordnet. Die Phase gibt Auskunft darüber, inwieweit die betrachtete Sinusfunktion gegenüber einer Referenzsinusfunktion nach links oder rechts verschoben ist. Die Fouriertransformation enthält auch Informationen zum Kontrast, also dem Unterschied in den Helligkeiten des hellsten und dunkelsten Punktes im Ortsraum (entsprechend Maxima und Minima der Sinusfunktion oder den hellen und dunklen Streifen im Interferenzmuster). Schließlich enthält die Fouriertransformation bei der Ortsfrequenz Null ein Hauptmaximum, das die durchschnittliche Helligkeit des betrachteten Bereichs im Ortsraum repräsentiert. Bei einem Interferenzmuster wäre dieser Wert also immer größer Null. Sehr anschauliche Erläuterungen zu den Eigenschaften der Fouriertransformation sowie zum Verhältnis der Darstellungen im Ortsraum (Streifenmuster und andere Helligkeitsbilder) und im Ortsfrequenzraum (die entsprechenden Fouriertransformierten) sind dem Artikel "An Intuitive Explanation of Fourier Theory" von Steven Lehar unter der Website http://sharp.bu.edu/~slehar/fourier/fourier.html zu entnehmen. Das dort Behandelte sei für folgende Betrachtungen als Grundwissen vorausgesetzt.

Die eindimensionale Fouriertransformation erhält man aus obiger Gleichung für f (x, y) mit y=0. Zur Berechnung einer Fouriertransformation wird ganz überwiegend ein Algorithmus angewandt, den man als Fast-Fouriertransformation (FFT) bezeichnet. Hierfür wird zunächst die mathematische Integration bei obiger Gleichung durch eine Summation ersetzt. Analog muss die Exponentialfunktion abgewandelt werden, so dass man für den eindimensionalen Fall erhält

$$F(\omega_k) = \sum_{n=0}^{N-1} f_n \cdot e^{-i\omega_k n}$$

$k = 0, 1, \cdots, N - 1$

mit $\omega_k = \dfrac{k 2\pi}{N}$, $\quad k = 0, 1, \ldots, N\text{-}1.$

Mit $W = e^{\frac{-i2\pi}{N}}$ ergibt sich aus obiger Gleichung für die diskrete Fouriertransformierte

$$F_k = \sum_{n=0}^{N-1} f_n \cdot W^{k \cdot n}.$$

Einen analogen Ausdruck lässt sich für eine zweidimensionale Fouriertransformation angeben. Dies ist der Ausgangspunkt des besagten Algorithmus der FFT, bei dem die benötigte Rechenzeit optimiert ist. Nähere Details zu den mathematischen Grundlagen der Fouriertransformation und des Algorithmus der Fast-Fouriertransformation finden sich in umfangreicher Fachliteratur. Gleiches gilt für die physikalischen Grundlagen der Interferometrie. Explizit sei in diesem Zusammenhang auf das Lehrbuch "Optik" von E. Hecht, Addison-Wesely Publishing Company verwiesen. In der zweiten Auflage von 1992 der deutschen Ausgabe findet sich ein Kapitel über Interferenz (Kapitel 9) und eines über Fourieroptik (Kapitel 11).

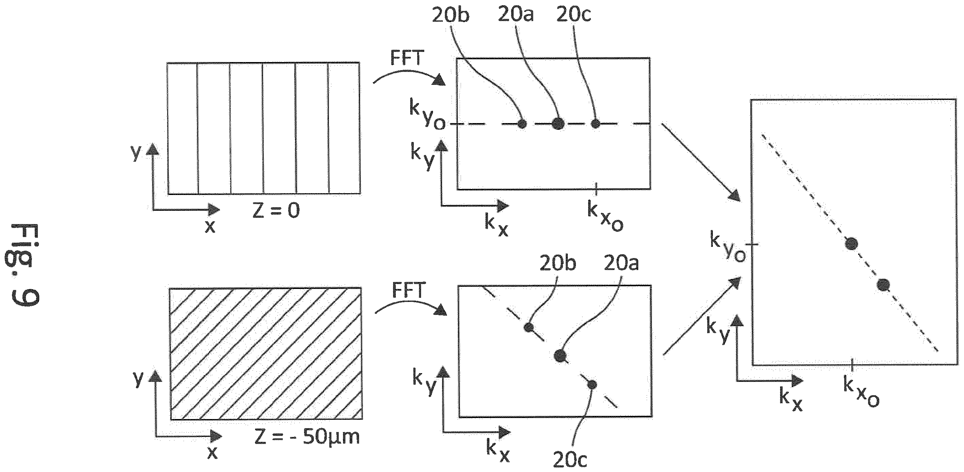

Figur 9 zeigt exemplarisch die Ergebnisse der Fouriertransformation (zweidimensionale FFT) bei einem Interferenzstreifenmuster 10, wie es schematisch in Figur 7, linke Hälfte, für z=0 und z= -50 $\mu$m dargestellt ist.

Für den Fall z=0 erhält man die Grundinterferenz eines senkrecht verlaufenden Interferenzstreifenmusters, während bei einer Defokussierung auf z= -50 $\mu$m die Streifen 11, 12 geneigt sind und etwas dichter liegen. Die zugehörigen Fouriertransformierten zeigen jeweils ein Hauptmaximum 20a, das die durchschnittliche Bildhelligkeit beschreibt, sowie die Nebenmaxima 20b, 20c. Deren Lage ist charakteristisch für die Ortsfrequenzen des jeweiligen Streifenmusters in den beiden Raumrichtungen x und y.

Ein Vergleich der Bilder der beiden Fouriertransformierten zeigt, dass sich die Lage der Nebenmaxima 20b, 20c absolut und auch relativ zueinander ändert. Beispielsweise lassen sich die Koordinaten des rechten Nebenmaximums 20c für viele z-Positionen ermitteln und zu einer Kalibrierkurve zusammensetzen. Es zeigt sich, dass die Koordinaten $(k_x, k_y)$ dieser Vielzahl von Nebenmaxima 20c auf einer Geraden liegen. Eine solche Gerade eignet sich besonders bevorzugt als Steuerkurve für die Fokuseinstellung, wie noch erläutert wird.

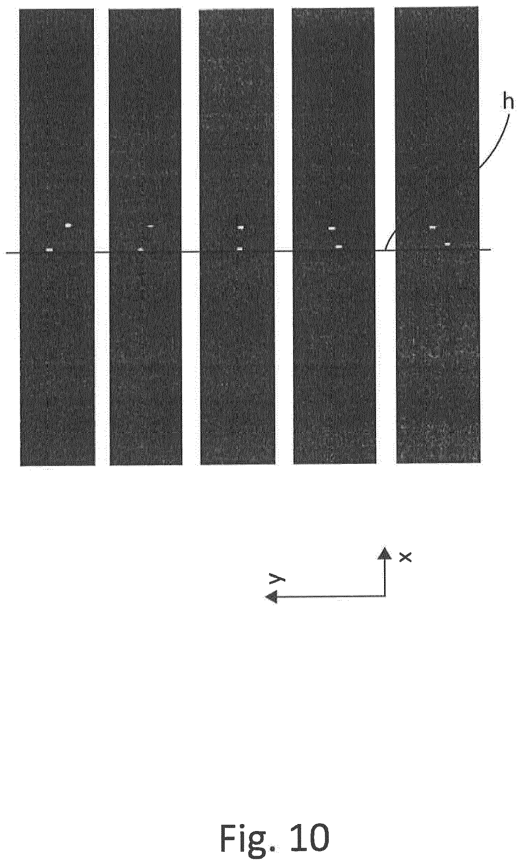

Figur 10 zeigt fünf Abbildungen von Fouriertransformierten, wie sie nach dem anhand von Figur 9 erläuterten Verfahren bei Fokusstellungen von z= -50 μm, - 25 μm, 0 μm, + 25 μm und + 50 μm erhalten werden. Dargestellt sind die beiden Nebenmaxima 20b, 20c als weiße Punkte. Anhand der angezeigten Hilfslinie h lässt sich leicht erkennen, wie sich beispielsweise das linke Nebenmaximum 20b von oben nach unten betrachtet leicht nach rechts bewegt und sich noch stärker nach unten verschiebt.

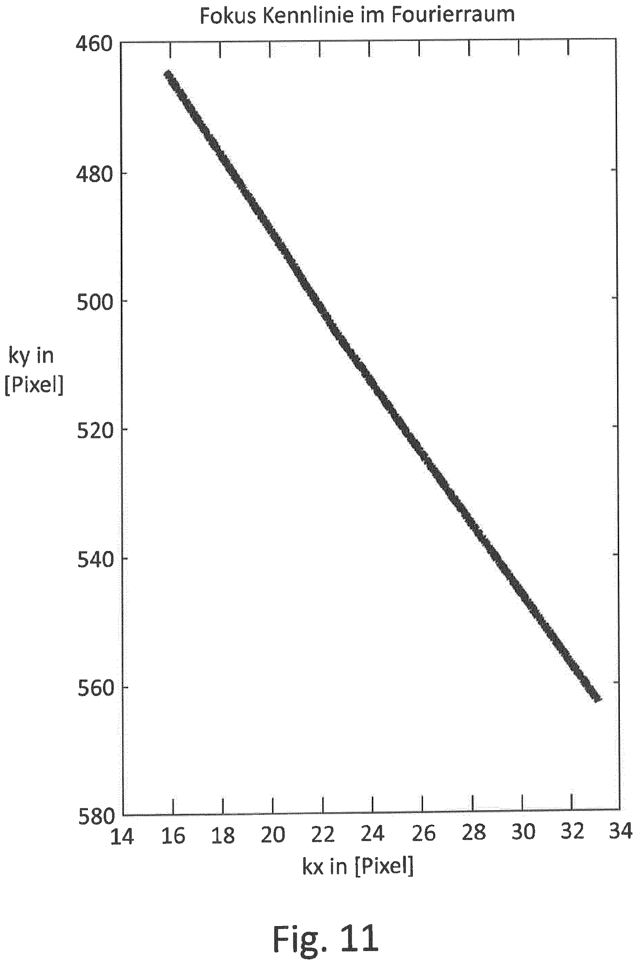

Figur 11 zeigt nochmals eine Darstellung der im Folgenden als Fokus-Kennlinie bezeichneten Geraden, wie sie durch Auftragen der $k_x$ und $k_y$ Koordinaten eines der Nebenmaxima 20b, 20c erhalten werden kann. Alternativ zu dieser Darstellung kann eine Darstellung gewählt werden, bei der die Werte $k_y$ über z (oder $k_x$ über z) aufgetragen sind, wobei z die jeweilige Fokusposition (optimale Fokussierung bei z = 0) bezeichnet. Auch bei dieser alternativen Darstellungsform erhält man eine lineare Fokus-Kennlinie.

Ausgehend von der in Figur 11 dargestellten Fokus-Kennlinie kann die Fokuseinstellung wie folgt vorgenommen werden: Ein bestimmter Koordinatenwert $(k_{x0}, k_{y0})$ repräsentiert einen Punkt auf der Geraden, der der optimalen Fokuseinstellung entspricht. Es sei darauf hingewiesen, dass die Einheiten der beiden Achsen in Figur 11 willkürlich (als Pixel) gewählt sind. Das Interferenzmuster wird zum Zwecke der Autofokussierung mehrmals pro Sekunde, beispielsweise 20x pro Sekunde, ausgewertet. Hierzu wird das Interferenzstreifenmuster zweidimensional mittels FFT fouriertransformiert. Aus der Fouriertransformation werden, wie anhand von Figur 9 beschrieben, die Koordinaten eines Nebenmaximums ermittelt. Sind diese Koordinaten ungleich $(k_{x0}, k_{y0})$, so liegt eine Defokussierung vor, die von der Autofokuseinrichtung durch entsprechende Veränderung des Abstandes zwischen Autofokus-Grenzfläche 7 und Objektiv 2 rückgängig gemacht wird. Es ist vorteilhaft, wenn zu diesem Zweck ein Regelkreis vorhanden ist, der Abweichungen vom Fokus derart auf Null regelt, dass die gemessenen Koordinaten $(k_x, k_y)$ den Fokuskoordinaten $(k_{x0}, k_{y0})$ entsprechen. Die Fokuseinstellung erfolgt in der Regel durch Ansteuerung des Mikroskoptisches.

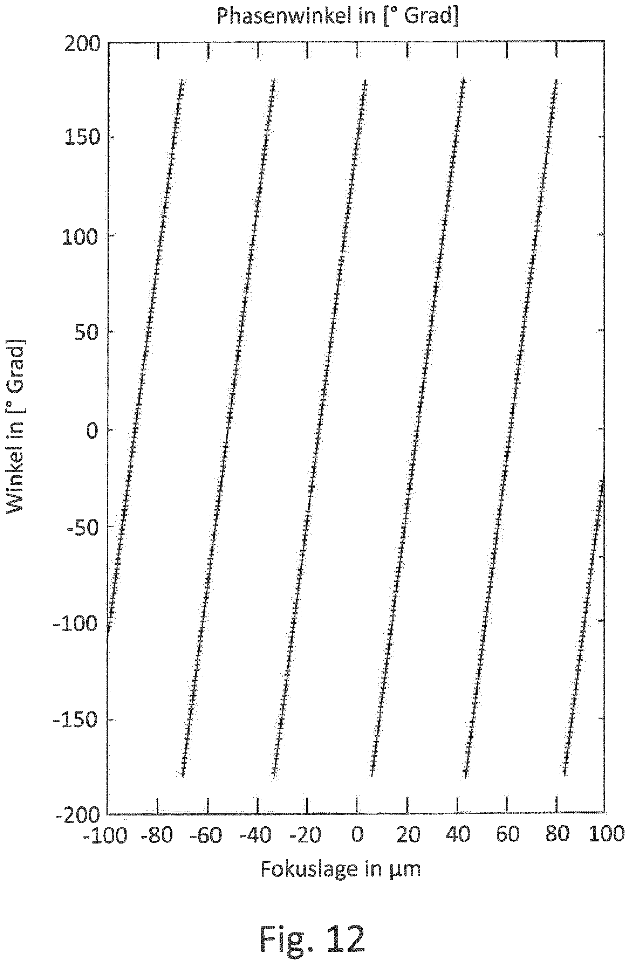

Figur 12 zeigt ein weiteres Charakteristikum des Interferenzstreifenmusters, nämlich den Phasenwinkel, der sich ebenfalls aus der Fouriertransformierten des Interferenzstreifenmusters 10 bestimmen lässt. Dieser ist angegeben in Grad und aufgetragen gegen die Fokuslage in μm. Gut zu erkennen ist der steile Verlauf der Geraden, die jeweils nach Durchlaufen des Winkelbereichs zwischen -180 und +180 Grad zurück auf -180 Grad "springen". Aufgrund der großen Steigung der Geraden bietet der Phasenwinkel eine Möglichkeit, bereits geringste Abweichungen aus der Fokuslage zuverlässig zu detektieren. Aufgrund des "Rücksprungs" der Gerade nach jeweils etwa 40 μm in z-Richtung (Fokuslage) ist die Regelung über den Phasenwinkel nur eindeutig in einem Bereich von < 40 μm um den Fokus herum möglich.

Es hat sich daher als besonders vorteilhaft gezeigt, die anhand von Figur 11 beschriebene Regelung mit der anhand von Figur 12 beschriebenen Regelung zu kombinieren. Beispielsweise lässt sich mit einem Objektiv 20x/0.70 mit einer Regelung gemäß Figur 11 ein Fokusbereich von +/- 150 μm mit einer Fokussiergenauigkeit von +/- 1 μm abdecken. Der Wert von 1 μm entspricht in etwa der Schärfentiefe des Objektivs. Nutzt man zusätzlich eine Regelung gemäß Figur 12, also bezieht man die Auswertung des Phasenwinkels zusätzlich in die Regelung ein, kann man eine Genauigkeit von 1/3 μm, entsprechend 1/3 Tiefenschärfe, erreichen. Diese Zweistufigkeit ist sinnvoll, da der Phasenwinkel, wie beschrieben, nicht eindeutig ist und sich somit die Streifendichte als Grundregelung und der Phasenwinkel als Feinregelung sinnvoll ergänzen.

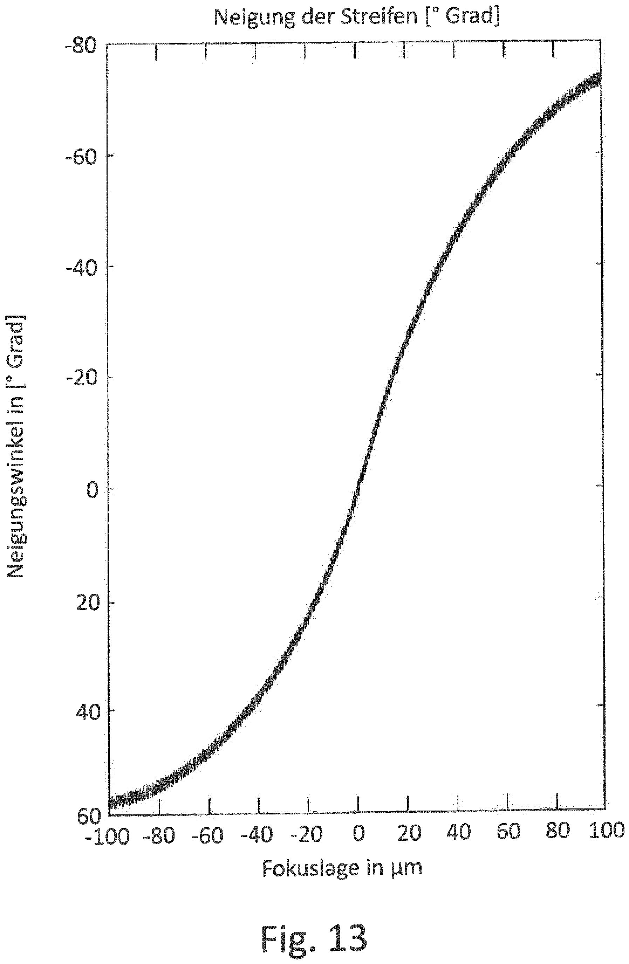

Figur 13 zeigt ein weiteres Charakteristikum der Interferenzstreifen, nämlich die bereits behandelte Neigung der Streifen in Grad aufgetragen gegen die Fokuslage in μm. Es ist zu erkennen, dass je nach Einstellung der "Grundinterferenz" ein bestimmter Neigungswinkel, hier 0 Grad, vorhanden ist (vgl. Figur 7, linke Hälfte). Bei Defokussierung in positiver Richtung der Z-Achse stellt sich ein Neigungswinkel der Interferenzstreifen ein, der zunächst nahezu linear ansteigt, um dann mit abnehmender Steigung einer Sättigung zuzustreben. Das gleiche Verhalten zeigt sich bei umgekehrtem Vorzeichen für eine Defokussierung in negativer Richtung der z-Achse. Der Verlauf des Neigungswinkels gemäß Figur 13 zeigt, dass auch diese Kurve als Steuerkurve für die Fokuseinstellung verwendbar ist. In der Praxis zeigt sich jedoch, dass eine lineare Steuerkurve (wie die der Figuren 11 und 12) regelungstechnisch einfacher umzusetzen ist. Zudem zeigt sich, dass die Fokus-Kennlinie gemäß Figur 11 und der Phasenwinkel gemäß Figur 12 empfindlichere Messgrößen darstellen als die Neigung der Streifen.

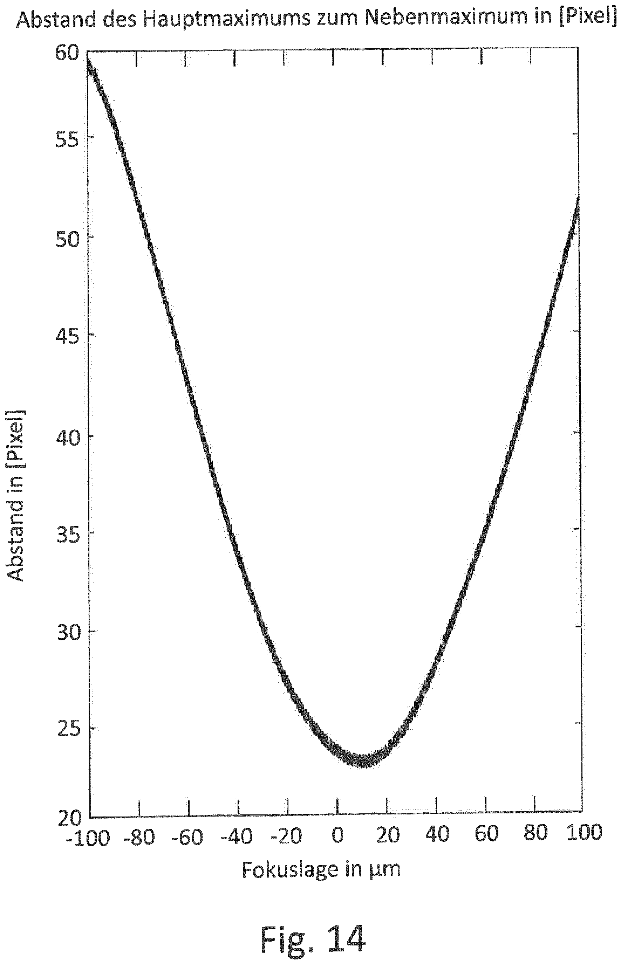

Schließlich zeigt Figur 14 noch ein weiteres Charakteristikum der Interferenzstreifen, nämlich den Abstand des Hauptmaximums zu einem der Nebenmaxima der zweidimensionalen Fouriertransformierten, aufgetragen als Abstand in Pixel gegen die Fokuslage in μm. Es zeigt sich ein parabelförmiger Verlauf, der bei richtiger Ausrichtung der Keilplatte symmetrisch zur Fokuslage Null ist. Aufgrund des parabelförmigen Verlaufs ist dieses Charakteristikum nicht eindeutig bezüglich der Fokuslage, d. h. es ergeben sich gleiche Werte für zwei Fokuslagen, die jeweils den gleichen Abstand von besagtem Scheitelpunkt besitzen.

Die geschilderten Ausführungsbeispiele zeigten bevorzugte Auswertemöglichkeiten bestimmter Charakteristika des Interferenzstreifenmusters bzw. seiner Fouriertransformierten. Die Beispiele sollen die Erfindung nicht einschränken, sondern vielmehr das Potential und die Vorteile der Erfindung darstellen. Die Erfindung eignet sich selbstverständlich nicht nur zur Autofokussierung bei den behandelten inversen Mikroskopen, sondern auch bei aufrechten Mikroskopen. Bezüglich aufrechter Mikroskope kann man sich die Figuren 4a und 4b auf den Kopf gedreht vorstellen, wobei dann der Petrischalenboden 15 einem auf dem Objekt 3 liegenden Deckglas entspricht. Ansonsten gelten sämtliche Betrachtungen in analoger Weise.

Bezugszeichenliste

| 1 | Mikroskop |
|---|---|
| 2 | Mikroskopobjektiv |
| 3 | Objektiv, Probe |
| 4 | Autofokusstrahlengang |
| 5 | Umlenkeinrichtung |
| 6, 6' | Begrenzungsfläche |
| 7 | Autofokus-Grenzfläche |
| 8 | Autofokuseinrichtung |
| 9 | Autofokusdetektor |
| 10 | Interferenzmuster |
| 11 | Streifen (hell) |
| 12 | Streifen (dunkel) |
| 13 | Petrischale |
| 14 | Luft |
| 15 | Petrischalenboden |
| 16 | Autofokusbeleuchtungsoptik |
| 16a | Lichtquelle |
| 16b | Beleuchtungslinse |
| 17 | Mikroskoptisch |
| 17a | Durchlichtöffnung |
| 18 | Beobachtungsoptik |
| 20a, 20b, 20c | Maxima |
| 21 | Fouriertransformierte |
| 22 | Autofokusauswerteeinheit |
| 23 | Fokuseinstelleinrichtung |
| 24 | Weißlichtquelle |
| 25 | Kollektor |
| 26 | Spektralfilter |
| 27 | Blende |
| 28 | Beleuchtungsoptik |
| 29 | Fokussierlinse |
| 30 | Leuchtfeldblende |
| 31 | Transportoptik |
| 32 | Transportlinse |
| 33 | Autofokus-Aperturblende |
| 34 | Umlenkprisma |
| 35 | Abbildungsstrahlengang |
| 41, 42, 43, 44 | Teilstrahlen |
| 50 | Keilplatte |
| 51, 52, 53, 54 | Bereiche |
| y | Keilwinkel |
| h | Hilfslinie |

**Patentansprüche**

1. Verfahren zur Autofokussierung bei der mikroskopischen Untersuchung eines im Fokus eines Mikroskopobjektivs (2) eines Mikroskops (1) liegenden Objekts (3) unter Verwendung eines Autofokusstrahlengangs (4), wobei der Autofokusstrahlengang (4) über eine auf der objektabgewandten Mikroskopobjektivseite angeordnete Umlenkeinrichtung (5) in Richtung Mikroskopobjektiv (2) und von dort auf eine reflektierende Autofokus-Grenzfläche (7) im Objektbereich gelenkt wird, und der an der Autofokus-Grenzfläche (7) reflektierte Autofokusstrahlengang (4) über das Mikroskopobjektiv (2) und die Umlenkeinrichtung (5) in Richtung eines Autofokusdetektors (9) gelenkt wird, wobei die Umlenkeinrichtung (5) zur Erzeugung interferierender Teilstrahlen (41, 42, 43, 44) des Autofokusstrahlengangs (4) zwei in Ausbreitungsrichtung des Autofokusstrahlengangs (4) zueinander beabstandete und den Autofokusstrahlengang (4) jeweils reflektierende Bereiche (51, 52; 53, 54) aufweist, und wobei der Autofokusdetektor (9) in einer zur Mikroskopobjektivpupille konjugierten Ebene angeordnet ist, um ein dort erzeugtes Interferenzmuster aufzunehmen, wobei abhängig von dem aufgenommenen Interferenzmuster (10) der Fokus des Mikroskops (1) eingestellt wird, wobei zur Fokuseinstellung das aufgenommene Interferenzmuster (10) hinsichtlich Orientierung und/oder Dichte der Streifen (11, 12) im Interferenzmuster (10) und hinsichtlich des Phasenwinkels des Interferenzmusters (10) ausgewertet wird, und wobei die Fokuseinstellung zunächst anhand der Auswertung der Orientierung der Streifen oder der Streifendichte im Interferenzmuster (10) erfolgt, und dass zur Feineinstellung des Fokus zusätzlich der Phasenwinkel des Interferenzmusters (10) ausgewertet wird.

2. Verfahren nach Anspruch 1, **dadurch gekennzeichnet, dass** als Umlenkeinrichtung (5) ein den Autofokusstrahlengang (4) wenigstens zum Teil reflektierender dichroitischer Teiler eingesetzt wird, dessen zwei im Autofokusstrahlengang liegende Begrenzungsflächen (6, 6') die zwei beabstandeten, den Autofokusstrahlengang (4) reflektierenden Bereiche (51, 52, 53, 54) bilden.

3. Verfahren nach einem der Ansprüche 1 bis 2, **dadurch gekennzeichnet, dass** die zwei beabstandeten Bereiche (51, 52, 53, 54) der Umlenkeinrichtung (5) planparallel zueinander verlaufen.

4. Verfahren nach einem der Ansprüche 1 bis 2, **dadurch gekennzeichnet, dass** die zwei beabstandeten Bereiche (51, 52, 53, 54) der Umlenkeinrichtung (5) jeweils eben ausgebildet sind und keilförmig unter einem Keilwinkel ($\gamma$) zueinander verlaufen.

5. Verfahren nach Anspruch 4, **dadurch gekennzeichnet, dass** als Keilwinkel ($\gamma$) ein Winkel zwischen 0,5' bis 10', insbesondere bis 2', gewählt wird.

6. Verfahren nach einem der vorstehenden Ansprüche, **dadurch gekennzeichnet, dass** bei Verwendung eines im Objektbereich des Mikroskops (1) befindlichen Objektträgers mit einem Probenmedium und einem darauf angeordneten Deckglas als Autofokus-Grenzfläche (7) für den Fokus des Autofokusstrahlengangs (4) im Objektbereich entweder die Grenzfläche zwischen Deckglas und Probenmedium oder die dem Probenmedium abgewandte Grenzfläche zwischen Deckglas und der Luft verwendet wird.

7. Verfahren einem der Ansprüche 1 bis 5, **dadurch gekennzeichnet, dass** bei Verwendung einer im Objektbereich des Mikroskops (1) befindlichen Petrischale (13), die ein Probenmedium enthält, als Autofokus-Grenzfläche (7) für den Fokus des Autofokusstrahlengangs (4) im Objektbereich entweder die Grenzfläche zwischen dem Petrischalenboden (15) und dem Probenmedium oder die dem Probenmedium abgewandte Grenzfläche zwischen dem Petrischalenboden (15) und der Luft (14) unterhalb des Petrischalenbodens (15) verwendet wird.

8. Verfahren nach einem der Ansprüche 1 bis 7, **dadurch gekennzeichnet, dass** die Auswertung des Interferenzmusters (10) unter Einsatz einer Fouriertransformation, insbesondere einer Fast-Fouriertransformation, vorgenommen wird.

9. Verfahren nach Anspruch 8, **dadurch gekennzeichnet, dass** die Lage der Maxima (20a, 20b, 20c) in einem ebenen Koordinatensystem der Fouriertransformierten (21) des Interferenzmusters (10) bestimmt wird, und dass die relative Lage der Maxima (20a, 20b, 20c) zueinander und/oder die Lage eines der Maxima (20a, 20b, 20c) im Koordinatensystem der Fouriertransformierten (21) ausgewertet wird.

10. Mikroskop (1) mit einer Autofokuseinrichtung (8) zur Einstellung des Fokus des ein Mikroskopobjektiv (2) enthaltenden Mikroskops (1) mit

einer Autofokusbeleuchtungsoptik (16) zur Erzeugung eines Autofokusstrahlengangs (4), mit einem Autofokusdetektor (9) und mit einer auf der objektabgewandten Mikroskopobjektivseite angeordneten Umlenkeinrichtung (5) zum Lenken des Autofokusstrahlengangs (4) in Richtung Mikroskopobjektiv (2) und von dort auf eine reflektierende Autofokus-Grenzfläche (7) in einem Objektbereich und zum Lenken des an der Autofokus-Grenzfläche (7) reflektierten und das Mikroskopobjektiv (2) durchlaufenden Autofokusstrahlengangs (4) in Richtung des Autofokusdetektors (9), wobei die Umlenkeinrichtung (5) zur Erzeugung interferierender Teilstrahlen (41, 42, 43, 44) des Autofokusstrahlengangs (4) zwei in Ausbreitungsrichtung des Autofokusstrahlengangs (4) zueinander beabstandete und den Autofokusstrahlengang (4) jeweils reflektierende Bereiche (51, 52, 53, 54) aufweist,

wobei der Autofokusdetektor (9) zur Aufnahme eines Interferenzmusters (10) in einer zur Mikroskopobjektivpupille konjugierten Ebene angeordnet ist,

einer Autofokusauswerteeinheit (22), mit der das aufgenommene Interferenzmuster(10) auswertbar ist, und mit einer Fokuseinstelleinrichtung (23), die zur Einstellung des Fokus des Mikroskops (1) mit der Autofokusauswerteeinheit (22) in Wirkverbindung steht,

bei dem die Autofokusauswerteeinheit (22) zur Auswertung des aufgenommenen Interferenzmusters (10) hinsichtlich Orientierung und/oder Dichte der Streifen (11, 12) im Interferenzmuster (10) und des Phasenwinkels des Interferenzmusters (10) ausgebildet ist, und

bei dem die Autofokusauswerteeinheit (22) weiterhin derart ausgestaltet ist, dass die Streifendichte im Interferenzmuster oder die Streifenorientierung des Interferenzmusters (10) auswertbar ist, um basierend auf dieser Auswertung die Fokuseinstelleinrichtung (23) zu einer ersten Fokuseinstellung zu veranlassen, und dass weiterhin der Phasenwinkel des Interferenzmusters (10) auswertbar ist, um basierend aus dieser Auswertung die Fokuseinstelleinrichtung (23) zu einer Fokusfeineinstellung zu veranlassen.

11. Mikroskop nach Anspruch 10, bei dem die Umlenkeinrichtung (5) einen den Autofokusstrahlengang (4) zumindest zum Teil reflektierenden dichroitischen Teiler aufweist, dessen zwei im Autofokusstrahlengang (4) liegende Begrenzungsflächen (6, 6') die zwei beabstandeten, den Autofokusstrahlengang (4) reflektierenden Bereiche (51, 52, 53, 54) bilden.

12. Mikroskop nach Anspruch 11, bei dem der dichroitische Teiler als planparallele Platte ausgebildet ist und bei dem die zwei beabstandeten Bereiche (51, 52; 53, 54) der Umlenkeinrichtung (5) planparallel zueinander verlaufen.

13. Mikroskop nach Anspruch 11, bei dem der dichroitische Teiler als Keilplatte (50) mit einem Keilwinkel ($\gamma$) ausgebildet ist und bei dem die zwei beabstandeten Bereiche (51, 52; 53, 54) der Umlenkeinrichtung (5) jeweils eben ausgebildet sind und keilförmig unter einem Keilwinkel ($\gamma$) zueinander verlaufen.

14. Mikroskop nach Anspruch 13, bei dem der Keilwinkel ($\gamma$) 0,5' bis 10', insbesondere bis 2', beträgt.

15. Mikroskop nach einem der Ansprüche 10 bis 14, bei dem im Objektbereich des Mikroskops (1) ein Objektträger mit einem Probenmedium und einem darauf angeordneten Deckglas positionierbar ist und bei dem als Autofokus-Grenzfläche (7) für den Fokus des Autofokusstrahlengangs (4) entweder die Grenzfläche zwischen Deckglas und Probenmedium oder die dem Probenmedium abgewandte Grenzfläche zwischen Deckglas und der Luft verwendbar ist.

16. Mikroskop nach einem der Ansprüche 10 bis 14, bei dem im Objektbereich des Mikroskops (1) eine Petrischale (13), die ein Probenmedium enthält, positionierbar ist und bei dem als Autofokus-Grenzfläche (7) für den Fokus des Autofokusstrahlengangs (4) entweder die Grenzfläche zwischen dem Petrischalenboden (15) und dem Probenmedium oder die dem Probenmedium abgewandte Grenzfläche zwischen dem Petrischalenboden (15) und der Luft (14) unterhalb des Petrischalenbodens (15) verwendbar ist.

17. Mikroskop nach einem der Ansprüche 10 bis 16, bei dem die Fokuseinstelleinrichtung (23) derart ausgestaltet ist, um zur Einstellung des Fokus des Mikroskops (1) den Abstand des Mikroskopobjektivs (2) von der Autofokus-Grenzfläche (7) im Objektbereich zu verändern und/oder bei Einsatz eines Varioobjektivs als Mikroskopobjektiv (2) die Brennweite desselbigen zu verändern.

18. Mikroskop nach einem der Ansprüche 10 bis 17, das als inverses Mikroskop (1) ausgebildet ist.

19. Mikroskop nach einem der Ansprüche 10 bis 18, bei dem die Autofokusbeleuchtungsoptik (16) eine Weißlichtquelle (24), insbesondere mit einem monochromen Filter (26), oder eine LED-Lichtquelle (16a) aufweist.

20. Computerprogramm mit Programmcode-Mitteln, um alle Schritte eines Verfahrens gemäß einem der Ansprüche 1 bis 9 durchzuführen, wenn das Computerprogramm auf einem Computer oder einer entsprechenden Rechnereinheit, insbesondere der Autofokusauswerteeinheit (22) in einem Mikroskop (1) gemäß Anspruch 10, ausgeführt wird.

21. Computerprogrammprodukt mit Programmcode-Mitteln, die auf einem computerlesbaren Datenträger gespeichert sind, um alle Schritte eines Verfahrens nach einem der Ansprüche 1 bis 9 durchzuführen, wenn das Computerprogramm auf einem Computer oder einer entsprechenden Rechnereinheit, insbesondere der Autofokusauswerteeinheit (22) in einem Mikroskop (1) gemäß Anspruch 10, ausgeführt wird.

## Claims

1. Autofocusing method within the scope of the microscopic examination of an object (3) lying in the focus of a microscope objective (2) of a microscope (1) using an autofocus beam path (4), wherein the autofocus beam path (4) is directed via a deflection device (5) arranged on the microscope objective side facing away from the object in the direction of the microscope objective (2) and, from there, on a reflecting autofocus interface (7) in the object region, and wherein the autofocus beam path (4) reflected at the autofocus interface (7) is directed via the microscope objective (2) and the deflection device (5) in the direction of an autofocus detector (9),
wherein the deflection device (5), for the purposes of producing interfering partial beams (41, 42, 43, 44) of the autofocus beam path (4), has two reflecting regions (51, 52; 53, 54) that each reflect the autofocus beam path (4) and that are spaced apart from one another in the propagation direction of the autofocus beam path (4),
and wherein the autofocus detector (9) is arranged in a plane conjugate to the microscope objective pupil in order to record an interference pattern produced there,
wherein the focus of the microscope (1) is set depending on the recorded interference pattern (10),
wherein the recorded interference pattern (10) is evaluated in respect of orientation and/or density of the fringes (11, 12) in the interference pattern (10) and in respect of the phase angle of the interference pattern (10) for the purposes of setting the focus, and
wherein the focus is initially set on the basis of the evaluation of the orientation of the fringes or the fringe density in the interference pattern (10) and in that the phase angle of the interference pattern (10) is additionally evaluated for finely setting the focus.

2. Method according to Claim 1, **characterized in that** a dichroic splitter that at least partly reflects the autofocus beam path (4) is used as deflection device (5), the two boundery surfaces (6, 6') of the said dichroic splitter lying in the autofocus beam path forming the two spaced-apart regions (51, 52, 53, 54) that reflect the autofocus beam path (4).

3. Method according to either of Claims 1 and 2, **characterized in that** the two spaced-apart regions (51, 52, 53, 54) of the deflection device (5) extend in a plane-parallel fashion with respect to one another.

4. Method according to either of Claims 1 and 2, **characterized in that** the two spaced-apart regions (51, 52, 53, 54) of the deflection device (5) each have a plane embodiment and extend in wedge-shaped fashion in relation to one another under a wedge angle ($\gamma$).

5. Method according to Claim 4, **characterized in that** an angle of between 0.5' and 10', in particular up to 2', is chosen as wedge angle ($\gamma$).

6. Method according to any one of the preceding claims, **characterized in that**, if use is made of an object carrier that is situated in the object region of the microscope (1) and comprises a sample medium and a coverslip arranged thereon, either the interface between the coverslip and the sample medium or the interface distant from the sample medium between the coverslip and the air is used as an autofocus interface (7) for the focus of the autofocus beam path (4) in the object region.

7. Method according to any one of Claims 1 to 5, **characterized in that**, if use is made of a petri dish (13) that is situated in the object region of the microscope (1) and that contains a sample medium, either the interface between the petri dish base (15) and the sample medium or the interface distant from the sample medium between the petri dish base (15) and the air (14) below the petri dish base (15) is used as an autofocus interface (7) for the focus of the autofocus beam path (4) in the object region.

8. Method according to any one of Claims 1 to 7, **characterized in that** the interference pattern (10) is evaluated using a Fourier transform, in particular a fast Fourier transform.

9. Method according to Claim 8, **characterized in that** the position of the maxima (20a, 20b, 20c) is determined in a plane coordinate system of the Fourier transform (21) of the interference pattern (10) and **in that** the relative position of the maxima (20a, 20b, 20c) in relation to one another and/or the position of one of the maxima (20a, 20b, 20c) in the coordinate system of the Fourier transform (21) is evaluated.

10. Microscope (1) comprising an autofocus device (8) for setting the focus of the microscope (1) containing a microscope objective (2), comprising

an autofocus illumination optical unit (16) for producing an autofocus beam path (4), comprising an autofocus detector (9) and comprising

a deflection device (5), arranged on the microscope objective side facing away from the object, for directing the autofocus beam path (4) in the direction of the microscope objective (2) and, from there, onto a reflecting autofocus interface (7) in an object region, and for directing the autofocus beam path (4) that has been reflected at the autofocus interface (7) and that has passed through the microscope objective (2) in the direction of the autofocus detector (9), wherein the deflection device (5), for the purposes of producing interfering partial beams (41, 42, 43, 44) of the autofocus beam path (4), has two reflecting regions (51, 52, 53, 54) that each reflect the autofocus beam path (4) and that are spaced apart from one another in the propagation direction of the autofocus beam path (4), wherein the autofocus detector (9) is arranged in a plane conjugate to the microscope objective pupil in order to record an interference pattern (10),

an autofocus evaluation unit (22), by means of which the recorded interference pattern (10) is evaluable, and comprising

a focus adjustment device (23), which has an operative connection to the autofocus evaluation unit (22) for setting the focus of the microscope (1),

wherein the autofocus evaluation unit (22) is configured to evaluate the recorded interference pattern (10) in respect of orientation and/or density of the fringes (11, 12) in the interference pattern (10) and the phase angle of the interference pattern (10), and

wherein the autofocus evaluation unit (22) is furthermore configured in such a way that the fringe density in the interference pattern or the fringe orientation of the interference pattern (10) is evaluable in order to prompt the focus adjustment device (23) to a first focus setting on the basis of this evaluation and in that, furthermore, the phase angle of the interference pattern (10) is evaluable in order to prompt the focus adjustment device (23) to finely set the focus on the basis of this evaluation.

11. Microscope according to Claim 10, wherein the deflection device (5) has a dichroic splitter that at least partly reflects the autofocus beam path (4), the two boundery surfaces, (6, 6') of the said dichroic splitter lying in the autofocus beam path (4) forming the two spaced-apart regions (51, 52, 53, 54) that reflect the autofocus beam path (4).

12. Microscope according to Claim 11, wherein the dichroic splitter is embodied as a plane parallel plate and wherein the two spaced-apart regions (51, 52; 53, 54) of the deflection device (5) extend in a plane-parallel fashion with respect to one another.

13. Microscope according to Claim 11, wherein the dichroic splitter is embodied as a wedge plate (50) with a wedge angle ($\gamma$) and wherein the two spaced-apart regions (51, 52; 53, 54) of the deflection device (5) each have a plane embodiment and extend in wedge-shaped fashion in relation to one another under a wedge angle (Y) .

14. Microscope according to Claim 13, wherein the wedge angle ($\gamma$) is 0.5' to 10', in particular up to 2'.

15. Microscope according to any one of Claims 10 to 14, wherein an object carrier with a sample medium and a coverslip arranged thereon is positionable in the object region of the microscope (1) and wherein either the interface between the coverslip and the sample medium or the interface distant from the sample medium between the coverslip and the air is usable as an autofocus interface (7) for the focus of the autofocus beam path (4).

16. Microscope according to any one of Claims 10 to 14, wherein a petri dish (13) containing a sample medium is positionable in the object region of the microscope (1) and wherein either the interface between the petri dish base (15) and the sample medium or the interface distant from the sample medium between the petri dish base (15) and the air (14) below the petri dish base (15) is usable as an autofocus interface (7) for the focus of the autofocus beam path (4).

**17.** Microscope according to any one of Claims 10 to 16, wherein, in order to set the focus of the microscope (1), the focus adjustment device (23) is configured to change the distance between the microscope objective (2) and the autofocus interface (7) in the object region and/or change the focal length of a zoom lens should the latter be used as a microscope objective (2).

**18.** Microscope according to any one of Claims 10 to 17, embodied as an inverted microscope (1).

**19.** Microscope according to any one of Claims 10 to 18, wherein the autofocus illumination optical unit (16) has a white-light source (24), in particular comprising a monochrome filter (26), or an LED light source (16a).

**20.** Computer program comprising program code means to carry out all steps of a method according to any one of Claims 1 to 9 if the computer program is executed on a computer or a corresponding computer unit, in particular the autofocus evaluation unit (22) in a microscope (1) according to Claim 10.

**21.** Computer program product comprising program code means stored on a computer-readable data medium to carry out all steps of a method according to any one of Claims 1 to 9 if the computer program is executed on a computer or a corresponding computer unit, in particular the autofocus evaluation unit (22) in a microscope (1) according to Claim 10.

**Revendications**

**1.** Procédé de focalisation automatique lors de l'analyse microscopique d'un objet (3) se trouvant dans le foyer d'un objectif de microscope (2) d'un microscope (1) en utilisant un trajet des rayons de focalisation automatique (4), le trajet des rayons de focalisation automatique (4) étant dévié par un dispositif de déviation (5) disposé sur la face détournée de l'objet du microscope en direction de l'objectif de microscope (2) et de là sur une surface limite de focalisation automatique (7) réfléchissante dans la zone d'objet, et le trajet des rayons de focalisation automatique (4) réfléchi au niveau de la surface limite de focalisation automatique (7) étant dévié par l'objectif de microscope (2) et le dispositif de déviation (5) en direction d'un détecteur de focalisation automatique (9),
le dispositif de déviation (5) présentant, pour générer des rayons partiels interférents (41, 42, 43, 44) du trajet des rayons de focalisation automatique (4), respectivement deux zones (51, 52 ; 53, 54) espacées l'une de l'autre dans le sens d'élargissement du trajet des rayons de focalisation automatique (4) et réfléchissant respectivement le trajet des rayons de focalisation automatique (4),
et le détecteur de focalisation automatique (9) étant disposé dans un plan conjugué à la pupille d'objectif de microscope pour recevoir un modèle d'interférence qui y est généré,
dans lequel, en fonction du modèle d'interférence reçu (10), le foyer du microscope (1) est réglé, pour régler le foyer, le modèle d'interférence (10) reçu est évalué au niveau de l'orientation et/ou de la densité des franges d'interférences (11, 12) dans le modèle d'interférence (10) et au niveau de l'angle de phase du modèle d'interférence (10), et
le réglage du foyer est d'abord évalué à partir de l'évaluation de l'orientation des bandes ou de la densité des franges d'interférences dans le modèle d'interférence (10), et, que pour le réglage de précision du foyer, l'angle de phase du modèle d'interférence (10) est évalué en complément.

**2.** Procédé selon la revendication 1, **caractérisé en ce qu'**est utilisé comme dispositif de déviation (5) un diviseur dichroïque réfléchissant au moins en partie le trajet des rayons de focalisation automatique (4) dont les deux surfaces de délimitation (6, 6') se trouvant dans le trajet des rayons de focalisation automatique constitue les deux zones (51, 52, 53, 54) espacées réfléchissant le trajet des rayons de focalisation automatique (4).

**3.** Procédé selon une des revendications 1 à 2, **caractérisé en ce que** les deux zones espacées (51, 52, 53, 54) du dispositif de déviation (5) sont orientées parallèlement en plan l'une à l'autre.

**4.** Procédé selon une des revendications 1 à 2, **caractérisé en ce que** les deux zones espacées (51, 52, 53, 54) du dispositif de déviation (5) ont respectivement une conformation plane et sont orientées l'une par rapport à l'autre de manière cunéiforme suivant un angle de coin(γ).

**5.** Procédé selon la revendication 4, **caractérisé en ce qu'**est sélectionné comme angle de coin (γ) un angle compris entre 0,5' et 10', en particulier allant jusqu'à 2'.

**6.** Procédé selon une des revendications précédentes, **caractérisé en ce que**, en cas d'utilisation d'un support d'objet se trouvant dans la zone d'objet du microscope (1) et comportant un fluide d'échantillon et un verre de recouvrement disposé dessus servant de surface limite de focalisation automatique (7), on utilise, pour la focalisation du trajet des rayons de focalisation automatique (4) dans la zone d'objet, soit la surface limite entre le verre de recouvrement et le fluide d'échantillon, soit la surface limite détournée du fluide d'échantillon entre le verre de recouvrement et l'air.

**7.** Procédé selon une des revendications 1 à 5, **caractérisé en ce que**, en cas d'utilisation d'une boîte de Pétri (13) se trouvant dans la zone d'objet du microscope (1) et qui contient un fluide d'échantillon, on utilise comme surface limite de focalisation automatique (7) pour la focalisation du trajet des rayons de focalisation automatique (4) dans la zone d'objet, soit la surface limite entre le fond de la boîte de Pétri (15) et le fluide d'échantillon, soit la surface limite détournée du fluide d'échantillon entre le fond de la boîte de Pétri (15) et l'air (14) en dessous du fond de la boîte de Pétri (15).

**8.** Procédé selon une des revendications 1 à 7, **caractérisé en ce que** l'évaluation du modèle d'interférence (10) est effectuée en utilisant une transformation de Fourier, en particulier une transformation de Fourier rapide.

**9.** Procédé selon la revendication 8, **caractérisé en ce que** la position des maxima (20a, 20b, 20c) dans un système de coordonnées plan des éléments ayant subi une transformation Fourier (21) du modèle d'interférence (10) est définie, et **en ce que** la position relative des maxima (20a, 20b, 20c) les uns par rapport aux autres et/ou la position d'un des maxima (20a, 20a, 20c) dans le système de coordonnées des éléments ayant subi une transformation Fourier (21) est évaluée.

**10.** Microscope (1) équipé d'un dispositif de focalisation automatique (8) pour le réglage du foyer du microscope (1) contenant un objectif de microscope (2), comportant
une optique d'éclairage de focalisation automatique (16) pour générer un parcours optique de focalisation automatique (4) avec un détecteur de focalisation automatique (9) et
un dispositif de déviation (5) disposé sur la face de l'objectif de microscope détournée de l'objet pour dévier le parcours optique de focalisation automatique (4) en direction de l'objectif de microscope (2) et de là sur une surface limite de focalisation automatique (7) réfléchissante dans une zone d'objet et pour dévier le parcours optique de focalisation automatique (4) réfléchi au niveau de la surface limite de focalisation automatique (7) et traversant l'objectif de microscope (2) en direction du détecteur de focalisation automatique (9), le dispositif de déviation (5) présentant, pour générer des rayons partiels interférents (41, 42, 43, 44) du parcours optique de focalisation automatique (4), deux zones (51, 52, 53, 54) espacées l'une de l'autre dans le sens d'élargissement du parcours optique de focalisation automatique (4) et réfléchissant respectivement le parcours optique de focalisation automatique (4), le détecteur de focalisation automatique (9) destiné à recevoir un modèle d'interférence (10) étant disposé dans un plan conjugué à la pupille de l'objectif de microscope,
une unité d'évaluation de focalisation automatique (22) qui permet d'évaluer le modèle d'interférence reçu (10), et comportant
un dispositif de réglage de focalisation (23) qui, pour régler la focalisation de microscope (1), est en interaction avec l'unité d'évaluation de focalisation automatique (22),
dans lequel l'unité d'évaluation de focalisation automatique (22) est conçue pour évaluer le modèle d'interférence (10) reçu au niveau de l'orientation et/ou de la densité des bandes (11, 12) dans le modèle d'interférence (10) et l'angle de phase du modèle d'interférence (10), et
dans lequel l'unité d'évaluation de focalisation automatique (22) est en outre conçue pour que la densité des bandes dans le modèle d'interférence ou l'orientation des bandes du modèle d'interférence (10) puisse être évaluée, afin, en se basant sur cette évaluation, d'amener le dispositif de réglage de focalisation (23) à un premier réglage de focalisation et que, en outre, l'angle de phase du modèle d'interférence (10) puisse être évalué pour, en se basant sur cette évaluation, amener le dispositif de réglage de focalisation (23) à réaliser un réglage de focalisation de précision.

**11.** Microscope selon la revendication 10, dans lequel le dispositif de déviation (5) présente un diviseur dichroïque réfléchissant au moins en partie le parcours optique de focalisation automatique (4) dont les deux surfaces de délimitation (6, 6') se trouvant dans le parcours optique de focalisation automatique (4) constituent les deux zones (51, 52, 53, 54) espacées réfléchissant le parcours optique de focalisation automatique (4).

**12.** Microscope selon la revendication 11, dans lequel le diviseur dichroïque est réalisé sous forme d'une plaque parallèle en plan et dans lequel les deux zones espacées (51, 52 ; 53, 54) du dispositif de déviation (5) s'étendent parallèlement en plan l'une par rapport à l'autre.

**13.** Microscope selon la revendication 11, dans lequel le diviseur dichroïque est réalisé sous forme d'une plaque cunéiforme (50) dotée d'un angle de sommet (γ) et dans lequel les deux zones espacées (51, 52 ; 53, 54) du dispositif de déviation (5) sont respectivement conçues de manière plane et s'étendent l'une par rapport à l'autre de manière cunéiforme suivant un angle de coin (γ).

**14.** Microscope selon la revendication 13, dans lequel l'angle de coin (γ) est compris entre 0,5' et 10', en particulier vaut jusqu'à 2'.

**15.** Microscope selon une des revendications 10 à 14, dans lequel, dans la zone d'objet du microscope (1), un support d'objet comportant un fluide d'échantillon et un verre de recouvrement disposé dessus peut être positionné et dans lequel on peut utiliser comme surface limite de focalisation automatique (7), pour le foyer du parcours optique de focalisation automatique (4), soit la surface limite entre le verre de recouvrement et le fluide d'échantillon, soit la surface limite détournée du fluide d'échantillon entre le verre de recouvrement et l'air.

**16.** Microscope selon une des revendications 10 à 14, dans lequel, dans la zone d'objet du microscope (1), une boîte de Pétri (13) qui contient un fluide d'échantillon peut être positionnée et dans lequel on peut utiliser comme surface limite de focalisation automatique (7) pour le foyer du parcours optique de focalisation automatique (4) soit la surface limite entre le fond de la boîte de Pétri (15) et le fluide d'échantillon, soit la surface limite détournée du fluide d'échantillon entre le fond de la boîte de Pétri (15) et l'air (14) en dessous du fond de la boîte de Pétri (15).

**17.** Microscope selon une des revendications 10 à 16, dans lequel le dispositif de réglage de focalisation (23) est conçu pour, en vue du réglage du foyer du microscope (1), modifier la distance entre l'objectif de microscope (2) et la surface limite de focalisation automatique (7) dans la zone d'objet et/ou, en cas d'utilisation d'un objectif Vario en tant qu'objectif de microscope (2), modifier la distance focale de celui-ci.

**18.** Microscope selon une des revendications 10 à 17, qui est réalisé sous forme d'un microscope inversé (1).

**19.** Microscope selon une des revendications 10 à 18, dans lequel l'optique d'éclairage de focalisation automatique (16) présente une source de lumière blanche (24), en particulier dotée d'un filtre monochrome (26), ou une source lumineuse à LED (16a).

**20.** Programme informatique comportant des moyens de codage de programme pour réaliser toutes les étapes du procédé selon une des revendications 1 à 9 lorsque le programme informatique est exécuté sur un ordinateur ou une unité de calcul correspondante, en particulier l'unité d'évaluation de focalisation automatique (22) dans un microscope (1) selon la revendication 10.

**21.** Programme informatique comportant des moyens de codage de programme qui sont sauvegardés sur un support de données lisible par ordinateur pour réaliser toutes les étapes du procédé selon une des revendications 1 à 9 lorsque le programme informatique est exécuté sur un ordinateur ou une unité de calcul correspondante, en particulier l'unité d'évaluation de focalisation automatique (22) dans un microscope (1) selon la revendication 10.

Fig. 1

Fig. 2

Fig. 3

Fig. 4b

Fig. 4a

Fig. 5

Fig. 6

z+

0

12

11

-50μm

10

11

11

10

12

z-

# Fig. 7

Fig. 8

Fig. 9

Fig. 10

Fig. 11

Phasenwinkel in [° Grad]

Fig. 12

Fig. 13

Abstand des Hauptmaximums zum Nebenmaximum in [Pixel]

Fig. 14

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5136149 B1
- DE 19537376 A1
- DE 3219503 A1
- US 20040113043 A1
- US 7345814 B2
- DE 60116268 T2
- WO 2009092555 A1
- DE 2518047 A1
- US 20080142681 A1
- US 6081133 A
- JP S59116605 A
- JP 2007147749 A